# EUROPEAN PATENT APPLICATION

(11) **EP 4 632 821 A1**
(43) Date of publication of application: **15.10.2025**
(21) Application number: 24184780.5
(22) Date of filing: 26.06.2024
(51) Int. Cl.: H01L 29/40, H01L 29/423, H01L 29/78, H01L 21/336

(54) **SPLIT-GATE TRENCH SEMICONDUCTOR DEVICE HAVING STEPPED SHIELD ELECTRODE AND METHOD OF MANUFACTURING**

(30) Priority: 12.04.2024 US 202418634120
(71) Applicant: Semiconductor Components Industries, LLC, Scottsdale, AZ 85250 (US)
(72) Inventor: HOSSAIN, Zia, Tempe, AZ, 85283 (US); KUMAR, Fnu Viswanathan Naveen, Scottsdale, AZ, 85251 (US); YEDINAK, Joseph Andrew, Mountain Top, PA, 18707 (US)
(74) Representative: Manitz Finsterwald Patent- und Rechtsanwaltspartnerschaft mbB

(57) **Abstract**

A semiconductor device includes a body of semiconductor material and a trench within the body of semiconductor material. A stepped shield electrode is within the trench and includes a wide first portion and a narrower second portion below the first portion. A first dielectric separates the first portion from the body of semiconductor material. A second dielectric separates the second portion from the body of semiconductor material. A split gate electrode structure is within the trench and includes a first gate electrode proximate to a first side of the trench and second gate electrode proximate to a second side of the trench. A gate dielectric separates the first gate electrode from the body of semiconductor material and separates the second gate electrode from the body of semiconductor material. A third dielectric separates the stepped shield electrode from the first gate electrode and the second gate electrode.

## Description

### Cross-Reference to Related Applications

Not applicable.

### Technical Field

The present disclosure relates, in general, to electronics and, more particularly, to semiconductor device structures and methods of forming semiconductor devices.

### Background

Insulated gate field effect transistors (IGFETs) such as metal oxide semiconductor field effect transistors (MOSFETs), have been used in many power switching applications, such as dc-dc converters. In a typical MOSFET, a gate electrode provides turn-on and turn-off control with the application of an appropriate gate voltage. By way of example, in an N-type conductivity enhancement mode MOSFET, turn-on occurs when a conductive N-type conductivity inversion layer (i.e., channel region) is formed in a P-type conductivity body region in response to the application of a positive gate voltage, which exceeds an inherent threshold voltage. The inversion layer connects N-type conductivity source regions to N-type conductivity drain regions and allows for majority carrier conduction between these regions.

There is a class of MOSFET devices in which the gate electrode is formed in a trench that extends downward from a major surface of a semiconductor material, such as silicon. Current flow in this class of devices is primarily in a vertical direction through the device, and, as a result, device cells can be more densely packed. All else being equal, the more densely packed device cells can increase the current carrying capability and reduce on-resistance of the device. Certain trench MOSFET devices also include a shield electrode electrically isolated from a gate electrode within the same trench (shielded-gate trench MOSFET device) in a stacked configuration (i.e., gate electrode over shield electrode), and can be used in power conversion applications, such as synchronous BUCK converter circuits as well as others.

In a shielded-gate trench MOSFET device, a high shield resistance can increase the likelihood of unwanted gate turn-on, dynamic avalanche, or unclamped inductive switching (UIS) issues due to a capacitive coupling of the shield electrode to the gate electrode or the shield electrode to the drain of the MOSFET device. In a typical shield-gate trench MOSFET device with a stacked configuration, the shield conductor is brought to the surface of the device for contact to, for example, source metal. In previous configurations, using multiple shield contacts resulted in segments of the trench regions where the gate electrode was left floating. This impaired device performance.

In addition, certain previous split gate designs exhibited poor specific on-resistance (Rsp) performance especially for higher voltages (for example, 100 volts to 250 volts) because previous approaches were not compatible with increasing dopant concentration in the drift region of the device.

Accordingly, structures and methods are needed that, among other things, reduce gate capacitance, reduce gate-to-shield capacitance, and facilitate contacting the shield electrode without creating floating regions. It would be beneficial for such structures and method to facilitate an increased dopant concentration within the drift region to improve Rsp performance. It would be beneficial for such structures and methods to be readily manufacturable and to minimize any effects on other performance characteristics.

### Brief Description of the Drawings

FIG. 1 illustrates a partial cross-sectional view of a semiconductor device in accordance with the present description;
FIG. 2 illustrates a partial cross-sectional view of a semiconductor device in accordance with the present description;
FIG. 3 graphically illustrates electric field characteristics of semiconductor devices in accordance with the present description compared to previous semiconductor devices;
FIGS. 4A, 4B, 4C, 4D, and 4E illustrate partial cross-sectional views of a semiconductor device in accordance with the present description at earlier stages of manufacture;
FIGS. 5A, 5B, 5C, 5D, 5E, 5F, and 5G illustrate partial cross-sectional views of a semiconductor device in accordance with the present description at later stages of manufacture;
FIGS. 6A, 6B, 6C, 6D, 6E, 6F, 6G, 6H, and 6I illustrate partial sectional views of a semiconductor device in accordance with the present description at later stages of manufacture;
FIGS. 7A, 7B, 7C, and 7D illustrate partial cross-sectional views of a semiconductor device in accordance with the present description at various stages of manufacture;
FIGS. 8A, 8B, 8C and 8D illustrate partial cross-sectional views of a semiconductor device in accordance with the present description at various stages of manufacture.
FIG. 9A illustrates a partial top view of a semiconductor device in accordance with the present description;
FIGS. 9B and 9C illustrate partial cross-sectional views of the semiconductor device of FIG. 9A taken along reference line 9B'-9B' and reference line 9C'-9C' respectively;
FIG. 10A illustrates a partial top view of a semiconductor device in accordance with the present description;
FIGS. 10B and 10C illustrate partial cross-sectional views of the semiconductor device of FIG. 10A taken along reference line 10B'-10B' and reference line 10C'-10C' respectively;
FIG. 11A illustrates a partial top view of a semiconductor device in accordance with the present description;
FIG. 11B illustrates a partial cross-sectional view of the semiconductor device of FIG. 11A taken along reference line 11B'-11B';
FIG. 12A illustrates a partial top view of a semiconductor device in accordance with the present description;
FIGS. 12B, 12C, and 12D illustrate partial cross-sectional views of the semiconductor device of FIG. 12A taken along reference line 12B'-12B', reference line 12C'-12C', and reference line 12D'-12D' respectively;
FIG. 13A illustrates a partial top view of a semiconductor device in accordance with the present description; and
FIGS. 13B and 13C illustrate partial cross-sectional views of the semiconductor device of FIG. 13A taken along reference line 13B'-13B' and reference line 13C'-13C' respectively.

The following discussion provides various examples of semiconductor devices and methods of manufacturing semiconductor devices. Such examples are non-limiting, and the scope of the appended claims should not be limited to the particular examples disclosed. In the following discussion, the terms "example" and "e.g." are non-limiting.

For simplicity and clarity of the illustration, elements in the figures are not necessarily drawn to scale, and the same reference numbers in different figures denote the same elements. Additionally, descriptions and details of well-known steps and elements are omitted for simplicity of the description.

For clarity of the drawings, certain regions of device structures, such as doped regions or dielectric regions, trenches, or contacts may be illustrated as having generally straight-line edges and precise angular corners. However, those skilled in the art understand that, due to the diffusion and activation of dopants or formation of layers, the edges of such regions generally may not be straight lines and that the corners may not be precise angles.

Although the semiconductor devices are explained herein as certain N-type conductivity regions and certain P-type conductivity regions, a person of ordinary skill in the art understands that the conductivity types can be reversed and are also possible in accordance with the present description, considering any necessary polarity reversal of voltages, inversion of transistor type and/or current direction, etc.

In addition, the terminology used herein is for the purpose of describing particular examples only and is not intended to be limiting of the disclosure. As used herein, the singular forms are intended to include the plural forms as well, unless the context clearly indicates otherwise.

As used herein, "current-carrying electrode" means an element of a device that carries current through the device, such as a source or a drain of an MOS transistor, an emitter or a collector of a bipolar transistor, or a cathode or anode of a diode, and a "control electrode" means an element of the device that controls current through the device, such as a gate of a MOS transistor or a base of a bipolar transistor.

The term "major surface" when used in conjunction with a semiconductor region, wafer, or substrate means the surface of the semiconductor region, wafer, or substrate that forms an interface with another material, such as a dielectric, an insulator, a conductor, or a polycrystalline semiconductor. The major surface can have a topography that changes in the x, y and z directions.

In addition, structures of the present description can embody either a cellular-base design (in which the body regions are a plurality of distinct and separate cellular or stripe regions) or a single-base design (in which the body region is a single region formed in an elongated pattern, typically in a serpentine pattern or a central portion with connected appendages). However, one embodiment of the present description will be described as a cellular base design throughout the description for ease of understanding. It is understood that the present description encompasses both a cellular-base design and a single-base design.

The terms "comprises", "comprising", "includes", "including", "has", "have" and/or "having" when used in this description, are open ended terms that specify the presence of stated features, numbers, steps, operations, elements, and/or components, but do not preclude the presence or addition of one or more other features, numbers, steps, operations, elements, components, and/or groups thereof.

The term "or" means any one or more of the items in the list joined by "or". As an example, "x or y" means any element of the three-element set {(x), (y), (x, y)}. As another example, "x, y, or z" means any element of the seven-element set {(x), (y), (z), (x, y), (x, z), (y, z), (x, y, z)}.

Although the terms "first", "second", etc. may be used herein to describe various members, elements, regions, layers and/or sections, these members, elements, regions, layers and/or sections should not be limited by these terms. These terms are only used to distinguish one member, element, region, layer and/or section from another. Thus, for example, a first member, a first element, a first region, a first layer and/or a first section discussed below could be termed a second member, a second element, a second region, a second layer and/or a second section without departing from the teachings of the present disclosure.

It will be appreciated by one skilled in the art that words, "during", "while", and "when" as used herein related to circuit operation are not exact terms that mean an action takes place instantly upon an initiating action but that there may be some small but reasonable delay, such as propagation delay, between the reaction that is initiated by the initial action. Additionally, the term "while" means a certain action occurs at least within some portion of a duration of the initiating action.

The use of word "about", "approximately", or "substantially" means a value of an element is expected to be close to a state value or position. However, as is well known in the art there are always minor variances preventing values or positions from being exactly stated.

Unless specified otherwise, as used herein, the word "over" or "on" includes orientations, placements, or relations where the specified elements can be in direct or indirect physical contact.

Unless specified otherwise, as used herein, the word "overlapping" includes orientations, placements, or relations where the specified elements can at least partly or wholly coincide or align in the same or different planes.

It is further understood that the examples illustrated and described hereinafter suitably may have examples and/or may be practiced in the absence of any element that is not specifically disclosed herein.

### Description

In general, the present examples relate to semiconductor device structures and methods of making semiconductor devices, such as shielded-gate trench MOSFET devices, having improved manufacturability and performance. More particularly, structures and methods are described that reduce shield resistance, reduce capacitive coupling effects between the shield electrode and the gate electrode, improve specific on-resistance, and avoid using regions where the gate electrode is left floating. In a non-limiting example, the structures and methods are relevant to shielded-gate trench MOSFETs having a voltage rating between approximately 100V and 250V or more.

In some examples, a stepped shield electrode and a split gate electrode configuration is used that includes a thinner dielectric proximate to the body diode region of the semiconductor device, which facilitates a higher dopant concentration in the drift region to reduce specific on-resistance. In some examples, the lateral width of the upper shield electrode is reduced to provide a thicker sidewall dielectric between the shield electrode and the gate electrode, which facilitates a reduced cell pitch to further reduce specific on-resistance. In some examples, the stepped shield electrode or shield contacts at the surface of the semiconductor device can be continuous or intermittent along the length of trench. In some examples, the stepped shield electrode can be recessed in some segments within the trench where shield contacts are absent to provide design flexibility for setting shield resistance. In some examples, the stepped shield electrode can be intermittently recessed within the trench and covered by a dielectric to provide design flexibility for setting shield resistance and to reduce gate to shield capacitance.

In an example, a semiconductor device includes a body of semiconductor material including a top side, a bottom side opposite to the top side, and a first conductivity type. A trench extends from the top side into the body of semiconductor material. A stepped shield electrode is within the trench and includes a first portion comprising a first width and a second portion below and coupled to the first portion and comprising a second width less than the first width. A first dielectric separates the first portion from the body of semiconductor material. A second dielectric separates the second portion from the body of semiconductor material. A split gate electrode structure is within the trench and includes a first gate electrode proximate to a first side of the trench and second gate electrode proximate to a second side of the trench opposite to the first side, wherein the first gate electrode is laterally separated from the second gate electrode. A gate dielectric separates the first gate electrode from the body of semiconductor material at the first side of the trench and separates the second gate electrode from the body of semiconductor material at the second side of the trench. A third dielectric separates the stepped shield electrode from the first gate electrode and the second gate electrode.

In an example, a semiconductor device includes a body of semiconductor material including a top side, a bottom side opposite to the top side, and a first conductivity type. A trench within the body of semiconductor material extending inward from the top side. A stepped shield electrode within the trench includes a first portion comprising a first width, a second portion below and coupled to the first portion and comprising a second width less than the first width, and a third portion above and coupled to the first portion and comprising a third width less than the first width. A first dielectric separates the first portion from the body of semiconductor material. A second dielectric separates the second portion from the body of semiconductor material. A split gate electrode structure is within the trench and comprising a first gate electrode proximate to a first side of the trench and second gate electrode proximate to a second side of the trench opposite to the first side, wherein the first gate electrode is laterally separated from the second gate electrode. A gate dielectric separates the first gate electrode from the body of semiconductor material at the first side of the trench and separates the second gate electrode from the body of semiconductor material at the second side of the trench. A third dielectric separates the third portion of the stepped shield electrode from the first gate electrode and the second gate electrode, wherein the third dielectric is thicker than the gate dielectric.

In an example, a method of manufacturing a semiconductor device includes providing a body of semiconductor material including a top side, a bottom side opposite to the top side, and a first conductivity type. The method includes providing a trench extending from the top side into the body of semiconductor material. The method includes providing a stepped shield electrode within the trench including a first portion comprising a first width and a second portion below and coupled to the first portion and comprising a second width less than the first width. The method includes providing a first dielectric separating the first portion from the body of semiconductor material. The method includes providing a second dielectric separating the second portion from the body of semiconductor material. The method includes providing a split gate electrode structure within the trench and including a first gate electrode proximate to a first side of the trench and second gate electrode proximate to a second side of the trench opposite to the first side, wherein the first gate electrode is laterally separated from the second gate electrode. The method includes providing a gate dielectric separating the first gate electrode from the body of semiconductor material at the first side of the trench and separating the second gate electrode from the body of semiconductor material at the second side of the trench. The method includes providing a third dielectric separating the stepped shield electrode from the first gate electrode and the second gate electrode.

Other examples are included in the present disclosure. Such examples may be found in the figures, in the claims, or in the description of the present disclosure.

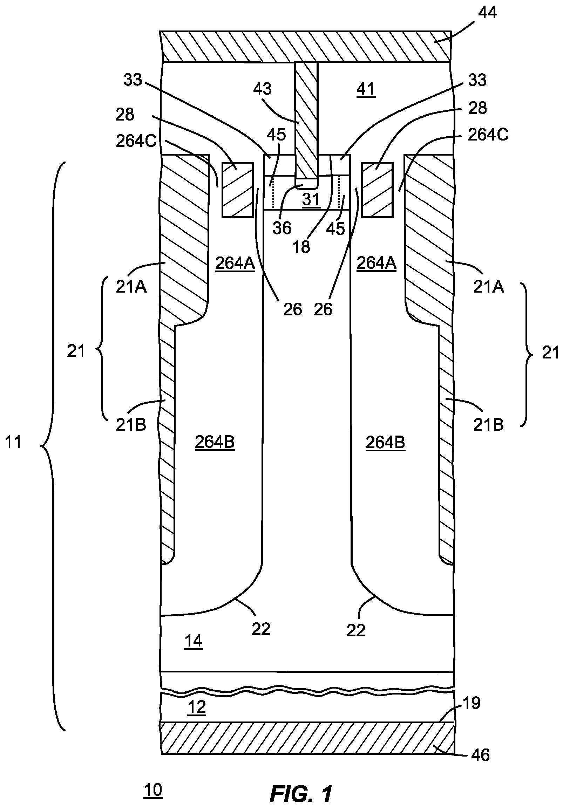

FIG. 1 illustrates a partial cross-sectional view of a semiconductor device 10 in accordance with the present description. In the present example, semiconductor device 10 is illustrated as an N-channel shielded-gate trench MOSFET comprising a split gate electrode and a stepped shield electrode configuration. It is understood that the present description is relevant to other semiconductor devices, including, but not limited to insulated gate bipolar transistor (IGBT) devices.

In some examples, semiconductor device 10 comprises a body of semiconductor material 11, which can also comprise or be referred to as a region of semiconductor material, a semiconductor workpiece, or a semiconductor wafer. In some examples, body of semiconductor material 11 can comprise a semiconductor substrate 12, which can comprise an N-type conductivity substrate with a resistivity in a range from about 0.001 ohm-cm to about 0.005 ohm-cm. Semiconductor substrate 12 can be doped with phosphorus, arsenic, or antimony. In the present example, semiconductor substrate 12 provides a first current-carrying region, drain, or drain region for semiconductor device 10. In some examples, body of semiconductor material 11 comprises silicon. In other examples, body of semiconductor material 11 or portions thereof can comprise other semiconductor materials, including, but not limited to silicon-germanium, silicon-germanium-carbon, carbon-doped silicon, silicon carbide, gallium nitride, or other related or equivalent materials as known to one of ordinary skill in the art. In the present example, semiconductor device 10 is illustrative of an active region portion of a semiconductor chip.

In some examples, body of semiconductor material 11 comprises a semiconductor region 14 formed on or overlying semiconductor substrate 12. Semiconductor region 14 can also comprise or be referred to as an as-formed region, an epitaxial region, or a semiconductor layer. In some examples, semiconductor region 14 comprises an N-type conductivity region formed using epitaxial growth or other deposition techniques. The dopant concentration, dopant profile, and thickness of semiconductor region 14 can be varied depending on the desired breakdown voltage (BV_{DSS}) characteristics of semiconductor device 10. By way of example for a higher voltage MOSFET device (that is, greater than 100V), semiconductor region 14 can be N-type conductivity, can be doped with phosphorous or arsenic, can comprise a dopant concentration in a range from about 1.0×10¹⁶ atoms/cm³ to about 1.0×10¹⁷ atoms/cm³, and can have thickness in a range from about 5 microns to about 10 microns. In accordance with the present description, at least a portion of semiconductor region 14 comprises a higher dopant concentration than previous devices and stepped shield electrodes 21 are configurated to maintain a desired breakdown voltage (BV_{DSS}) even with the higher dopant concentration.

In some examples, body of semiconductor material 11 includes a top side 18 and a bottom side 19 opposite to top side 18, which in the present example can be defined by semiconductor region 14 and semiconductor substrate 12 respectively. Top side 18 can also comprise or be referred to as a first side or an upper side and bottom side 19 can also comprise or be referred to as a second side or a lower side.

Semiconductor device 10 includes trenches 22 that extend from top side 18 into body of semiconductor material 11. In some examples, trenches 22 can terminate within semiconductor region 14. In other examples, trenches 22 can extend entirely through semiconductor region 14. In some examples, when body of semiconductor material 11 comprises silicon, trenches 22 can be formed using dry etching techniques with a fluorocarbon chemistry or a fluorinated chemistry (for example, SF₆/O₂). In accordance with the present description, semiconductor device 10 includes stepped shield electrodes 21 within trenches 22. In the present example, stepped shield electrodes 21 comprise a first portion 21A in an upper portion or mid portion of trenches 22 and a second 21B below and coupled to first portion 21A in a lower portion of trenches 22. In the present example, first portion 21A is laterally wider than second portion 21B so that a step is provided proximate to the transition from first portion 21A to second portion 21B in a cross-sectional view. It is evident that stepped shield electrodes 21 comprise a nonuniform lateral width along their vertical heights in the cross-sectional view. More particularly, first portion 21A comprises a first width in cross-sectional view and second portion 21B comprises a second width in the cross-sectional view that is less than the first width.

In accordance with the present description, first portion 21A is proximate to a doped region 31 of semiconductor device 10 and second portion 21B is located further vertically spaced apart from doped region 31. In some examples, stepped shield electrodes 21 comprise a doped polycrystalline semiconductor material, such as doped polysilicon. In some examples, stepped shield electrodes 21 can further comprise a silicide, a metal, or combinations thereof. Stepped shield electrodes 21 can also comprise or be referred to as stepped shield conductors, step shield electrodes, or step shield conductors.

In the present example, stepped shield electrodes 21 are insulated or separated from body of semiconductor material 11 by dielectric 264A and dielectric 264B. In accordance with the present description, dielectric 264A comprises a first thickness and dielectric 264B comprises a second thickness greater than the first thickness. In some examples, the first thickness can be in range from about 1,000 Angstroms to about 4,000 Angstroms. In some examples, the second thickness can be in a range from 5,000 Angstroms to about 12,000 Angstroms. In some examples, dielectric 264A and dielectric 264B can comprises an oxide, a nitride, or combinations thereof and can be formed using thermal growth techniques, deposition techniques, combinations thereof, or other techniques as known to one of ordinary skill in the art.

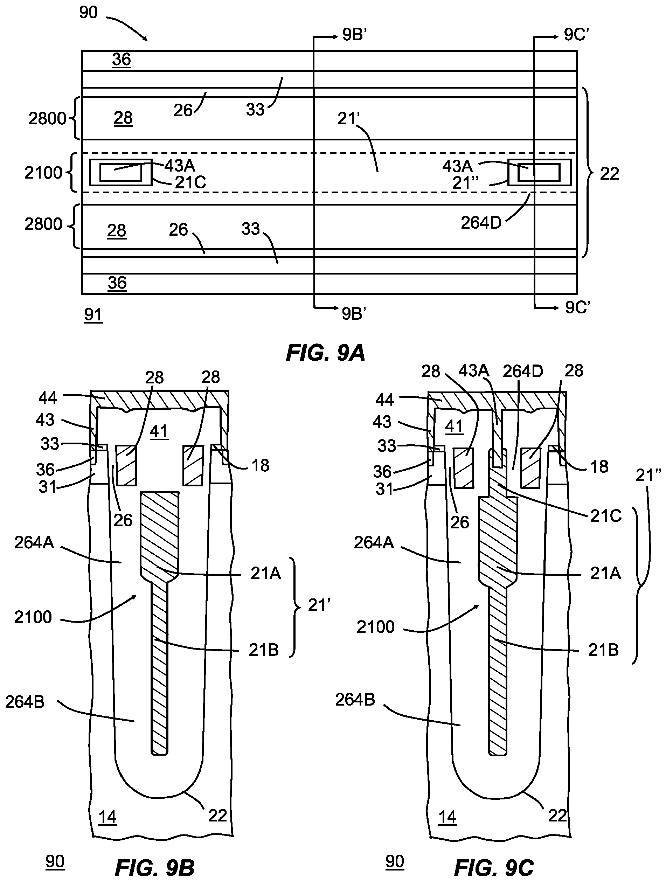

Semiconductor device 10 further includes gate electrodes 28, which, in the present example, are provided in a split gate structure or configuration. More particularly, portions of gate electrodes 28 are split or separated by a gap along the horizontal length of trenches 22 to accommodate contacts to stepped shield electrodes 21 at one or more locations within semiconductor device 10. A description of various example configurations is provided later in conjunction with FIGS. 9A-13C. In the present example, gate electrodes 28 are insulated or separated from body of semiconductor material 11 by gate dielectric 26 and are insulated or separated from stepped shield electrodes 21 by dielectric 264C. Gate electrodes 28 can also comprise or be referred to as gate conductors, split gate conductors, or split gate electrodes. Dielectric 264C can also comprise or be referred to as an inter-poly dielectric or an IPD.

In some examples, gate electrodes 28 comprise a conductive material, such as a doped polycrystalline semiconductor material. In some examples, gate electrodes 28 comprise polysilicon doped with an N-type conductivity dopant. In some examples, metals, silicides, combinations thereof, or other conductors can be included as part of gate electrodes 28. In some examples, gate dielectric 26 can comprise oxides, nitrides, tantalum pentoxide, titanium dioxide, barium strontium titanate, high k dielectric materials, combinations thereof, or other related or equivalent materials known by one of ordinary skill in the art. In some examples, gate dielectric 26 can be silicon oxide. In some examples, gate dielectric 26 can have a thickness from about 0.02 microns to about 0.1 microns. In some examples, dielectric 264C can comprise similar materials to dielectric 264A or gate dielectric 26. In some examples, dielectric 264C comprises an oxide and can have a thickness greater than the thickness of gate dielectric 26. In some examples, dielectric 264C comprises a thermal oxide, a deposited oxide, or a combination thereof. In some examples, based on the growth rate differences between polycrystalline silicon and single crystal silicon, dielectric 264C can have a thickness that is about 1.5 times (1.5X) to about 3 times (3X) the thickness of gate dielectric 26 depending on whether dry oxidation or wet oxidation is used to form gate dielectric 26 and dielectric 264C.

Semiconductor device 10 further includes doped region 31 of a P-type conductivity within semiconductor region 14 proximate to or adjacent to top side 18 and adjacent to upper portions of trenches 22. Doped region 31 can also comprise or be referred to as a body region or a base region. In some examples, doped region 31 can be formed using ion implantation and anneal techniques using a P-type dopant such as boron. Doped region 31 comprises a dopant concentration suitable for forming inversion layers that operate as conduction channels or channel regions 45 for semiconductor device 10. Doped region 31 can extend from top side 18 to a depth, for example, from about 0.3 microns to about 1.5 microns. In some examples, doped region 31 can be coupled to other doped regions 31 within semiconductor region 14 in a common base configuration. In other examples, doped region 31 can be a plurality of separated regions within semiconductor region 14. As illustrated in FIG. 1, first portion 21A of stepped shield electrode and dielectric 264A are adjacent semiconductor region 14 of body of semiconductor material 11 proximate to a bottom side of doped region 31, which is an upper portion of a drift region for semiconductor device 10. In accordance with the present description, this upper portion can be more highly doped compared to previous semiconductor devices because of the configuration of stepped shield electrode 21.

Semiconductor device 10 further includes doped region(s) 33 of N-type conductivity formed within, in or overlying doped region 31 and can extend from top side 18 to depth, for example, from about 0.1 micron to about 0.4 microns. Doped regions 33 can be formed using ion implantation and anneal techniques using an N-type dopant, such as phosphorous or arsenic. Doped regions 33 provide a second current carrying region for semiconductor device 10 and can also comprise or be referred to as source regions.

In some examples, a doped region 36 of P-type conductivity can be formed in a portion of doped region 31. Doped region 36 can also comprise or be referred to as a body contact, enhancement region, or contact region. In some examples, doped region 36 is configured to provide a low ohmic contact resistance to doped region 31. Ion implantation (for example, using boron) and anneal techniques can be used to form doped region 36.

In some examples, semiconductor device 10 further comprises interlayer dielectric (ILD) 41 above stepped shield electrodes 21, dielectric 264C, gate dielectric 26, and gate electrodes 28. In some examples, interlayer dielectric 41comprises silicon oxide, such as a doped or undoped deposited silicon oxide. In some examples, interlayer dielectric 41 can include one layer of deposited silicon oxide doped with phosphorous or boron and phosphorous and one layer of undoped oxide. In some examples, interlayer dielectric 41 can have a thickness from about 0.25 microns to about 1.5 microns. In some examples, interlayer dielectric 41 can be planarized to provide a more uniform surface topography, which improves manufacturability.

In some examples, semiconductor device 10 further comprises conductive region 43, which is configured in the present example to provide electrical contact to doped regions 33 and doped region 31 through doped region 36. In some examples, conductive region 43 comprises a conductive plug or a plug structure. In some examples, conductive region 43 can include a conductive barrier structure or liner and a conductive fill material. In some examples, the barrier structure can include a metal/metal-nitride configuration, such as titanium/titanium-nitride or other related or equivalent materials as known to one of ordinary skill in the art. In other examples, the barrier structure can further include a metal-silicide structure. In some examples, the conductive fill material includes tungsten. In some examples, conductive region 43 can be planarized to provide a more uniform surface topography.

In some examples, a conductor 44 can be formed over top side 18, and a conductor 46 can be formed adjacent to bottom side 19. Conductor 44 can also comprise or be referred to as a top metal or a top conductor, and conductor 46 can also comprise or be referred to as a bottom conductor or a back metal. Conductors 44 and 46 can be configured to provide electrical connection between the individual cells of semiconductor device 10 and a next level of assembly. In some examples, conductor 44 comprises titanium/titanium-nitride/aluminum-copper or other related or equivalent materials as known to one of ordinary skill in the art and is configured as a source electrode or terminal. In some examples, conductor 46 comprises a solderable metal structure such as titanium-nickel-silver, chromium-nickel-gold, or other related or equivalent materials known by one of ordinary skill in the art and is configured as a drain electrode or terminal. In some examples, a further passivation layer (not shown) can be formed adjacent to conductor 44. In some examples, stepped shield electrodes 21 can be coupled to conductor 44 so that stepped shield electrodes 21 are configured to be at the same potential as doped regions 33 when semiconductor device 10 is in use. In other examples, stepped shield electrodes 21 can be configured to be independently biased.

In some examples, the operation of device 10 can proceed as follows. Assuming that source electrode (or input terminal) 44 and stepped shield electrodes 21 are operating at a potential Vs of zero volts, gate electrodes 28 would receive a control voltage V_{G} of 10 volts, which is greater than the conduction threshold of semiconductor device 10 and drain electrode (or output terminal) 46 would operate at a drain potential V_{D} of less than 2.0 volts. The values of V_{G} and Vs would cause doped region 31 to invert adjacent gate electrodes 28 to form channel regions 45, which would electrically connect doped regions 33 to semiconductor region 14. A device current I_{DS} would flow from drain electrode 46 and would be routed through semiconductor region 14, channel regions 45, and doped regions 33 to source electrode 44. In one embodiment, I_{DS} is on the order of 10.0 amperes. To switch semiconductor device 10 to the off state, a control voltage V_{G} that is less than the conduction threshold of semiconductor device 10 would be applied to gate electrodes 28 (e.g., V_{G} < 1.0 volts). Such a control voltage would remove channel regions 45 and I_{DS} would no longer flow through semiconductor device 10.

In accordance with the present description, the configuration of semiconductor device 10 as described herein facilitates a higher doping concentration within semiconductor region 14 proximate to doped region 31. More particularly, the stepped shield electrodes 21 having wider portion 21A, narrow portion 21B, thinner dielectric 264A, and thicker dielectric 264B maintain the breakdown voltage of semiconductor device 10 with a higher doping concentration within semiconductor region 14. The configuration provides a lower specific on-resistance (R_{SP}) and UIS robustness.

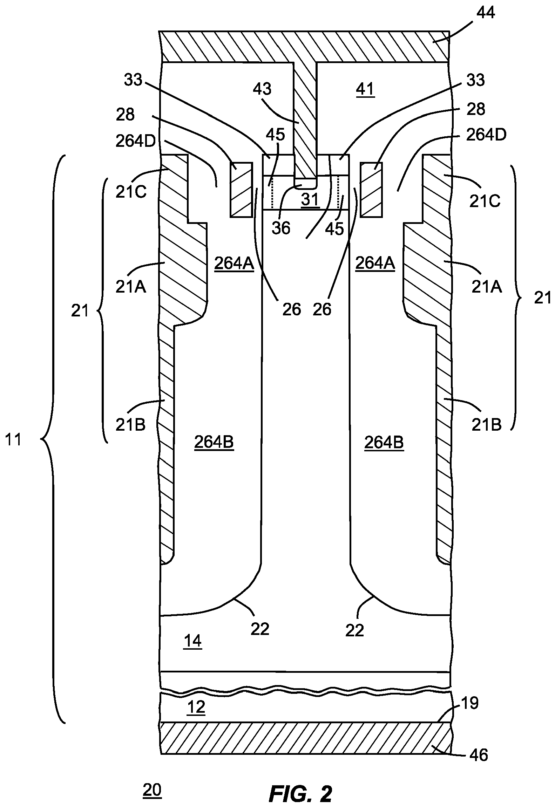

FIG. 2 illustrates a partial cross-sectional view of semiconductor device 20 in accordance with the present description. In the present example, semiconductor device 20 is illustrated as an N-channel shielded-gate trench MOSFET comprising a split gate electrode and a stepped shield electrode configuration. Semiconductor device 20 has some similarity in construction to semiconductor device 10 and such similarity will not be repeated here. In this regard, only distinctions between the two semiconductor devices will be discussed hereinafter.

In the present example, stepped shield electrodes 21 further comprise a third portion 21C above first portion 21A in the upper portion of trenches 22. In accordance with the present description, third portion 21C is laterally narrower than the first portion 21A. It will be apparent that one or more of stepped shield electrodes 21 in semiconductor device 20 comprise a first narrow portion, a wide portion, and second narrow portion over the vertical height of stepped shield electrodes 21. In some examples, third portion 21C can be wider than second portion 21B. In other examples, third portion 21C can be narrower than second portion 21B. In accordance with the present description, third portion 21C of stepped shield electrode 21 in semiconductor device 20 is laterally spaced away from gate electrode 28, which facilitates a thicker dielectric 264D compared to dielectric 264C of semiconductor device 10. In addition, dielectric 264D comprises a thickness greater than gate dielectric 26. The greater lateral separation of third portion 21C from gate electrode 28 with thicker dielectric 264D reduces the shield to gate capacitance in semiconductor device 20. This configuration also facilitates a smaller cell pitch, which provides semiconductor device 20 with a lower R_{SP}. In some examples, the thickness of dielectric 264D is less than or equal to the lateral width of third portion 21C.

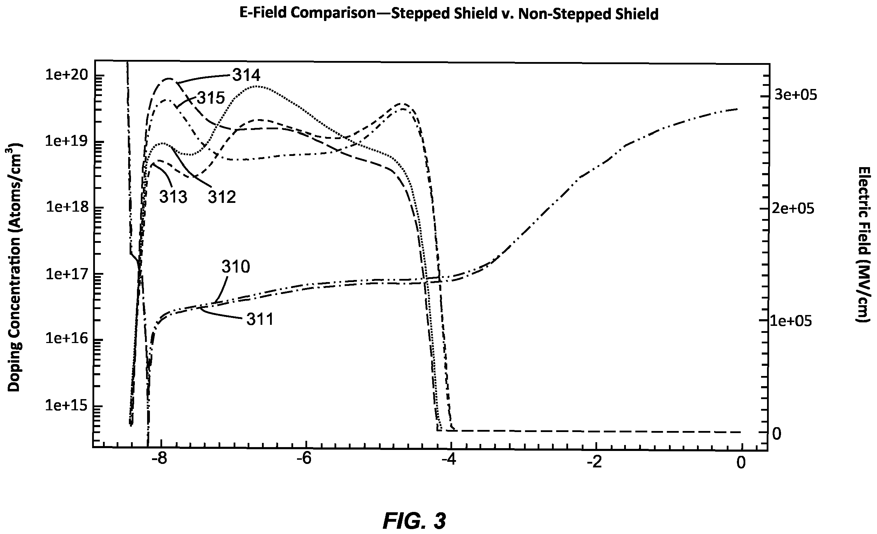

FIG. 3 graphically illustrates electric field characteristics of semiconductor device 10 with stepped shield electrode 21 compared to a previous semiconductor device that does not include a stepped shield electrode (i.e., has a shield dielectric with uniform thickness). The left y-axis is example dopant concentration in the body of semiconductor material, the x-axis is vertical location within the body of semiconductor material, and the right y-axis is electric field measurement. Data line 310 is a dopant concentration profile where the drift region has a resistivity of 0.1 ohm-cm and data line 311 is a dopant concentration profile where the drift region has a resistivity of 0.11 ohm-cm. It is noted that the body diode (PN junction) formed between doped region 31 and semiconductor region 14 is approximately to the left of data point -8 on the x-axis.

Data line 312 is electric field data for semiconductor device 10 with stepped shield electrode 21 with the drift region resistivity at 0.1 ohm-cm and data line 313 is electric field data for semiconductor device 10 with stepped shield electrode 21 with the drift region resistivity at 0.11 ohm-cm. Data line 314 is electric field data for a semiconductor device without a stepped shield electrode with the drift region resistivity at 0.1 ohm-cm and data line 315 is electric field data for a semiconductor device without a stepped shield electrode with the drift region resistivity at 0.11 ohm-cm. This data shows that without a stepped shield electrode 21, the electric field proximate to the body diode increases considerably with increasing drift region concentration, which results in a higher R_{SP}. With stepped shield electrode 21, the electric field proximate to the body diode is lower even with a higher doping concentration in the drift region as evidenced by data line 312. The increased drift region concentration improves R_{SP} and UIS performance.

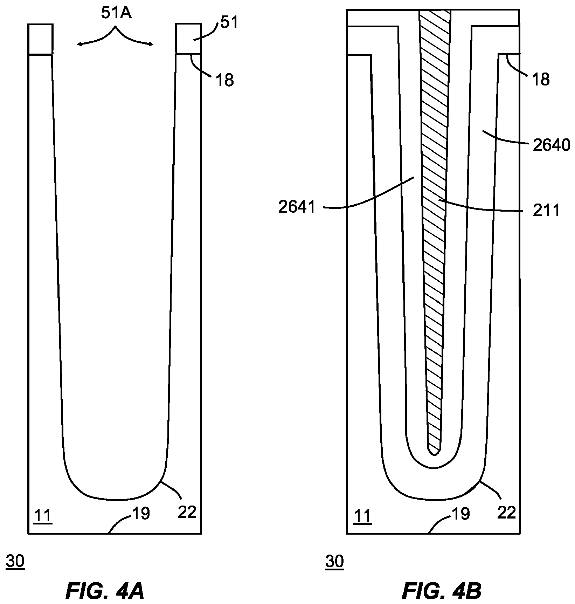

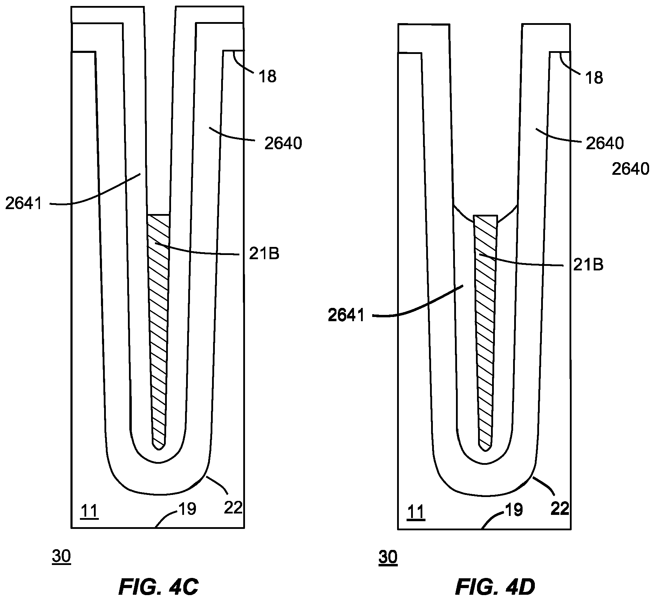

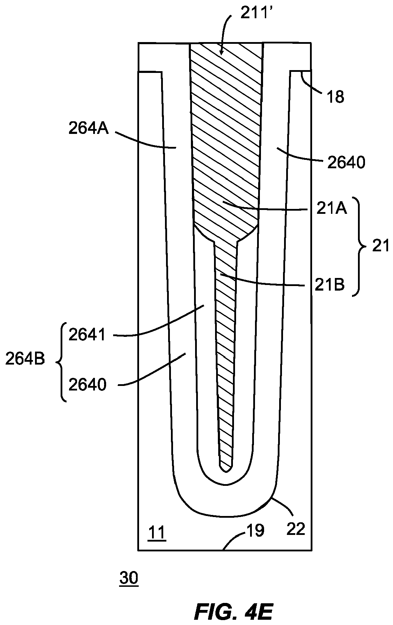

FIGS. 4A, 4B, 4C, 4D, and 4E illustrate partial cross-sectional views of a semiconductor device 30 comprising a stepped shield electrode 21 at early stages of fabrication in accordance with the present description. In some examples, the method described in FIGS. 4A-4E can be used to manufacture stepped shield electrodes 21 as described in FIGS. 1 and 2. In the present example, body of semiconductor material 11 is provided having top side 18 and bottom side 19. In some examples, body of semiconductor material 11 can include semiconductor substrate 12 and semiconductor region 14 as described previously. It is understood that in some examples, doped region 31, doped region 33, or doped region 36 can be provided before, during, or after the formation of stepped shield electrode 21 and are not illustrated hereinafter so as to not overly complicate the figures including FIGS 4A through 8D.

In some examples, a mask 51 is provided over top side 18 and patterned to provide an opening 51A for forming trench 22. In some examples, mask 51 comprises a hard mask, a polymer, or other protective materials. Trench 22 is provided by removing or etching a portion of body of semiconductor material 11 inward from top side 18 to a desired depth. In some examples, body of semiconductor material 11 can be etched with a fluorocarbon chemistry or a fluorinated chemistry (for example, SF₆/O₂) when body of semiconductor material 11 comprises silicon. In some examples, an angled etch is used. In some examples, trench 22 has a vertical depth in a range from about 3 microns to about 12 microns and lateral width in range from about 0.5 microns to about 2 microns.

FIG. 4B illustrates semiconductor device 30 after further processing. In some examples, a dielectric 2640 and a dielectric 2641 are provided within trench 22. The thicknesses of dielectric 2640 and dielectric 2641 are selected to not completely fill trench 22 but instead, leave a gap or a portion unfilled within trench 22 for a conductor 211. In some examples, dielectric 2640 comprises a material that is different than that of dielectric 2641. In the present example, the materials for dielectric 2640 and dielectric 2641 are selected to provide an etch selectivity where dielectric 2641 can be etched at a faster rate than dielectric 2640 using a selective etch chemistry. In some examples, dielectric 2640 can comprise a thermal oxide and dielectric 2641 can comprise a deposited material, such as deposited oxide or a deposited nitride. In some examples, dielectric 2640 is thicker than dielectric 2641. In some examples, the combined thicknesses of dielectric 2640 and 2641 can be in a range from about 4,000 Angstroms to about 12,000 Angstroms. In some examples, dielectric 2641 is provided using chemical vapor deposition (CVD), low-pressure CVD (LPCVD), plasma-enhanced CVD (PECVD), or other techniques as known to one ordinary skill in the art.

In the present example, conductor 211 is provided overlying dielectric 2641 within trench 22. In some examples, conductor 211 comprises polysilicon doped with an N-type dopant, such as phosphorous or arsenic. Conductor 211 can be provided using CVD, LPCVD, PECVD, or other techniques. In some examples, conductor 211 has a lateral width within trench 22 in a range from about 2,800 Angstroms to about 3,800 Angstroms. In some examples, conductor 211 can be planarized after deposition using, for example, chemical mechanical planarization (CMP) techniques.

FIG. 4C illustrates semiconductor device 30 after further processing. In the present example, conductor 211 is partially etched inward into trench 22 leaving portion 21B recessed within trench 22. In next steps, a portion of dielectric 2641 can be selectively etched to remove a portion of dielectric 2641 from the upper part of trench 22 while leaving another portion of dielectric 2641 in the lower part of trench 22 adjacent to portion 21B as illustrated in FIG. 4D. In some examples, dry etching techniques can be used to etch dielectric 2641.

FIG. 4E illustrates semiconductor device 30 after further processing. In the present example, a conductor 211' is provided within trench 22 adjacent to dielectric 2640, dielectric 2641 and portion 21B of conductor 211. In some examples, conductor 211' comprises polysilicon doped with an N-type dopant, such as phosphorous or arsenic and can be provided in a similar manner to conductor 211. In some examples, the top side of conductor 211' can be planarized using, for example, CMP techniques to provide portion 21A within trench 22 above and coupled to portion 21B.

It is evident from FIG. 4E that semiconductor device 30 comprises a stepped shield electrode 21 that includes portion 21A coupled to portion 21B where portion 21A is wider than portion 21B, which is similar to stepped shield electrode 21 having first portion 21A and second portion 21B in semiconductor device 10 and semiconductor device 20. In addition, the combined thicknesses of dielectric 2640 and dielectric 2641 in the lower part of trench 22 adjacent to portion 21B can be similar to dielectric 264B in semiconductor device 10 and semiconductor device 20. Further, dielectric 2640 in the upper part of trench 22 adjacent to portion 21A can be similar to dielectric 264A in semiconductor device 10 and semiconductor 20.

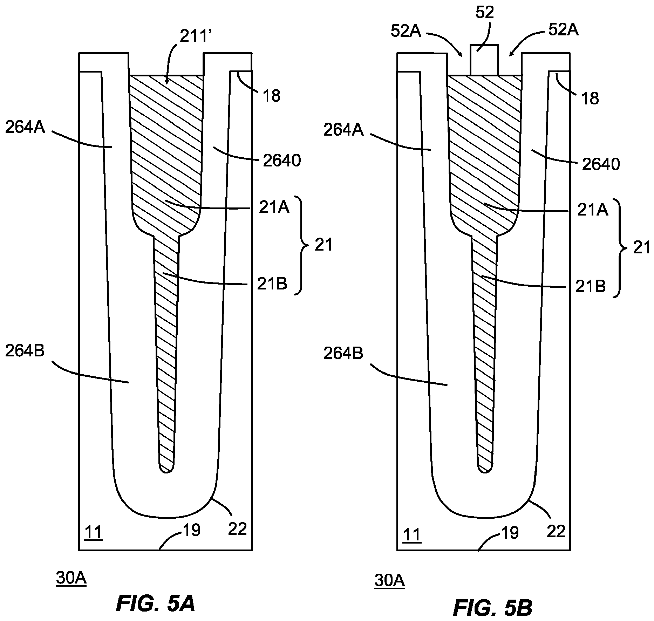

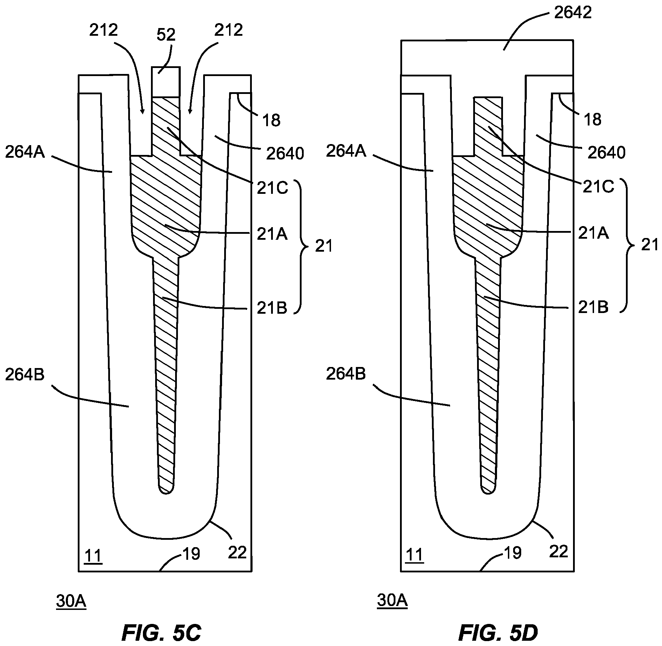

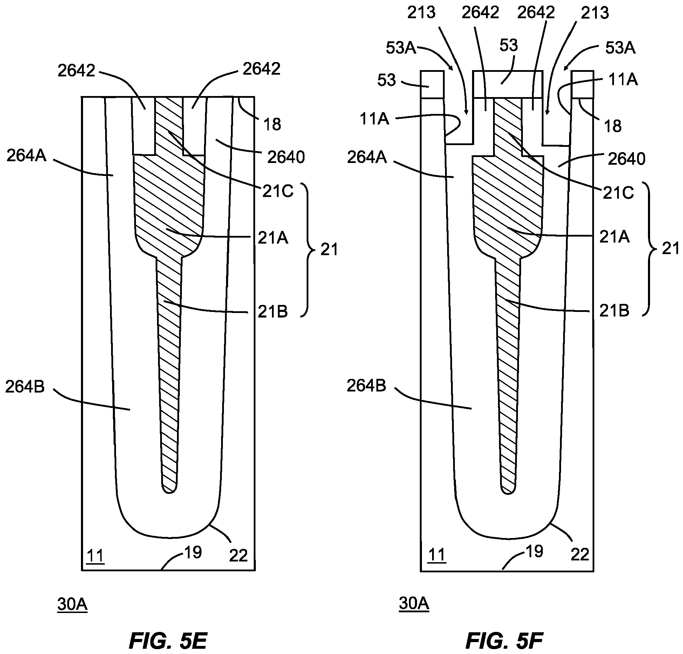

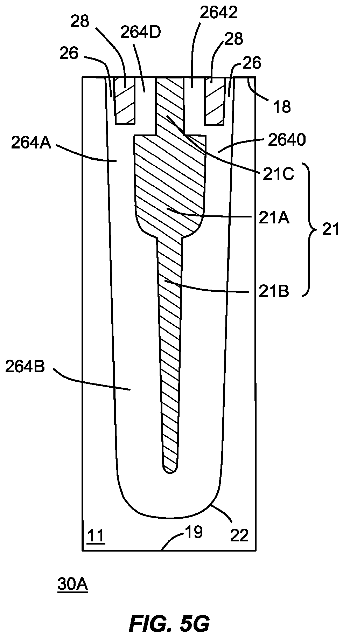

FIGS. 5A, 5B, 5C, 5D, 5E, 5F, and 5G illustrate partial cross-sectional views of a semiconductor device 30A in accordance with the present description at later stages of manufacture. In some examples, semiconductor device 30A can be provided based on the method described in FIGS. 4A-4E and is an example of a method that provides stepped shield electrode 21 comprising third portion 21C as shown in FIG. 2 for semiconductor device 20.

FIG. 5A illustrates semiconductor device 30A after conductor 211' is partially recessed below top side 18. In some examples, masking and etching techniques are used to provide the recessed structure as illustrated. In some examples, masking may not be used before the etching step to recess conductor 211'. In some examples, when conductor 211' comprises polysilicon, a fluorinated dry-etch chemistry, such as SF₆ can be used to recess conductor 211'. Next, a mask 52 is provided over stepped shield electrode 21 as illustrated in FIG. 5B. In some examples, mask 52 can comprise a polymer, such as a patterned photoresist. In the present example, mask 52 is provided having openings 52A that expose portions of stepped shield electrode 21.

FIG. 5C illustrates semiconductor device 30A after further processing. In the present example, exposed portions of conductor 211' can be etched to form recesses 212. In some examples, when conductor 211 comprises polysilicon, a fluorinated dry-etch chemistry can be used, such as SF₆ can be used to form recesses 212. In the present example, recesses 212 extend inward from top side 18 to define third portion 21C of stepped shield electrode 21. In the present example, recesses 212 terminate adjacent to first portion 21A of stepped shield electrode 21. In accordance with the present description, the width of mask 52 that overlies stepped shield electrode 21 can be used to set the lateral width of third portion 21C.

FIG. 5D illustrates semiconductor device 30A after further processing. In some examples, a dielectric 2642 is provided over top side 18 and within recesses 212. In some examples, dielectric 2642 comprises an oxide, a nitride, combinations thereof, or other materials as known to one of ordinary skill in the art. In some examples, dielectric 2642 comprises doped oxide. In some examples, dielectric 2642 comprises borosilicate glass (BSG) provided using CVD techniques. In a subsequent step, dielectric 2642 can be planarized. In some examples, dielectric 2642 is planarized down to be located proximate to top side 18 as illustrated in FIG. 5E. In some examples, CMP can be used to planarize dielectric 2642. In some examples, a top side of third portion 21C is exposed between portions of dielectric 2642 remaining within recesses 212. In some examples, the top side of third portion 21C is substantially coplanar with top side 18 of body of semiconductor material 11.

FIG. 5F illustrates semiconductor device 30A after further processing. In the present example, a mask 53 is provided over portions of dielectric 2642 and third portion 21C of stepped shield electrode 21. In some examples, mask 53 comprises a polymer material, such as a photoresist, which is patterned to provide openings 53A that expose portions of dielectric 2640 and dielectric 2642 proximate to top side 18. In some examples, portions of dielectric 2640 and dielectric 2642 are removed to provide recesses 213 extending inward from top side 18 into trench 22. In some examples, portions 11A of body of semiconductor material 11 can be exposed proximate to the upper part of trench 22. In some examples, drying etching techniques using a fluorinated chemistry can be used to form recesses 213. In some examples, after recesses 213 are formed, mask 53 is removed.

FIG. 5G illustrates semiconductor device 30A after further processing. In some examples, a sacrificial oxide can be provided along portions 11A within recesses 213 and then stripped to prepare portions 11A for gate dielectric 26. Gate dielectric 26 can then be provided along portions 11A within recesses 213. In some examples, gate dielectric 26 can comprise oxides, nitrides, tantalum pentoxide, titanium dioxide, barium strontium titanate, high k dielectric materials, combinations thereof, or other related or equivalent materials known by one of ordinary skill in the art. In some examples, gate dielectric 26 can be silicon oxide formed using thermal oxidation techniques. In some examples, gate dielectric 26 can have a thickness from about 0.02 microns to about 0.1 microns. Next, a conductor can be provided within recesses 213 over gate dielectric 26 and dielectric 2642. In some examples, the conductor comprises polysilicon doped with an N-type conductivity dopant. In some examples, the conductor can be planarized using CMP techniques to provide gate electrodes 28 within recesses 213 in a split gate configuration with third portion 21C laterally interposed between gate electrodes 28. In some examples, metals, silicides, or other conductors can be included as part of gate electrodes 28.

It is evident that gate electrodes 28 are laterally separated from third portion 21C and first portion 21A of stepped shield electrode 21 by dielectric 2642, which can be similar to dielectric 264D as illustrated in FIG. 2. In accordance with the present description, dielectric 264D is thicker than gate dielectric 26. In some examples, semiconductor 30A can be further processed to provide ILD 41, conductive region 43, conductor 44, and conductor 46 as illustrated and described with FIG. 2. As illustrated in FIG. 5G, a first gate electrode (for example, the left gate electrode 28) is proximate to a first side of trench 22 and a second gate electrode (for example, the right gate electrode 28) is proximate to a second side of trench 22 with the first gate electrode 28 laterally separated from the second gate electrode 28. The first gate electrode and the second gate electrode are examples of a split gate structure.

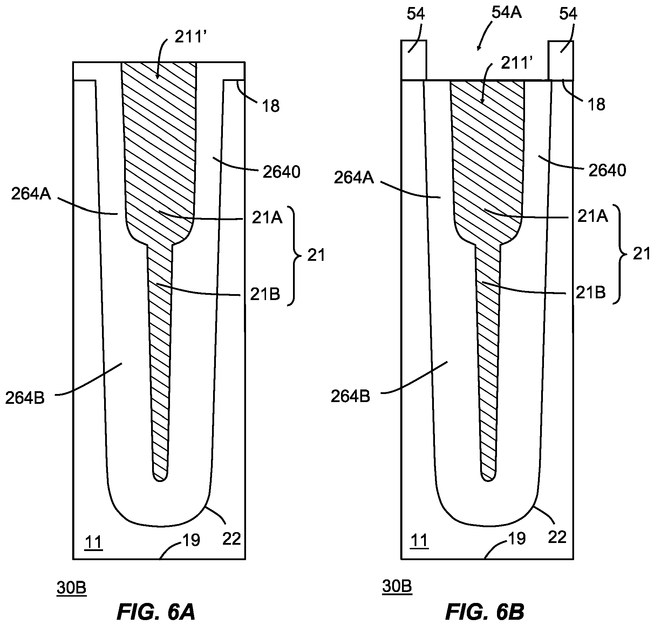

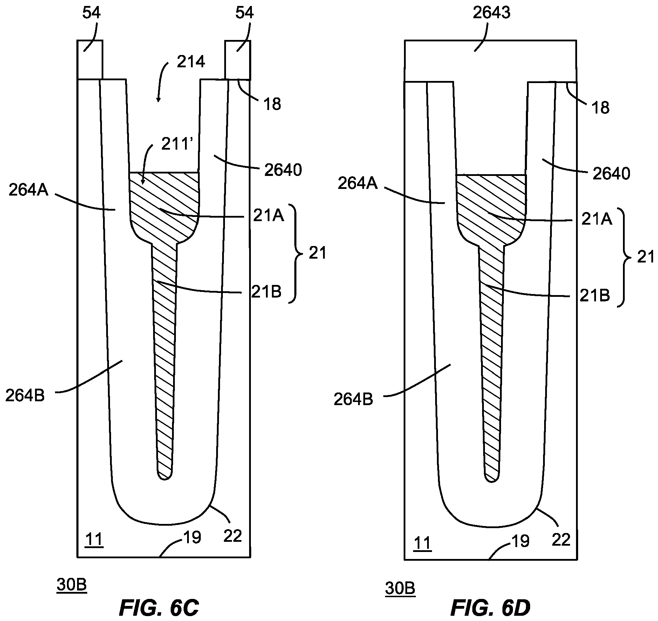

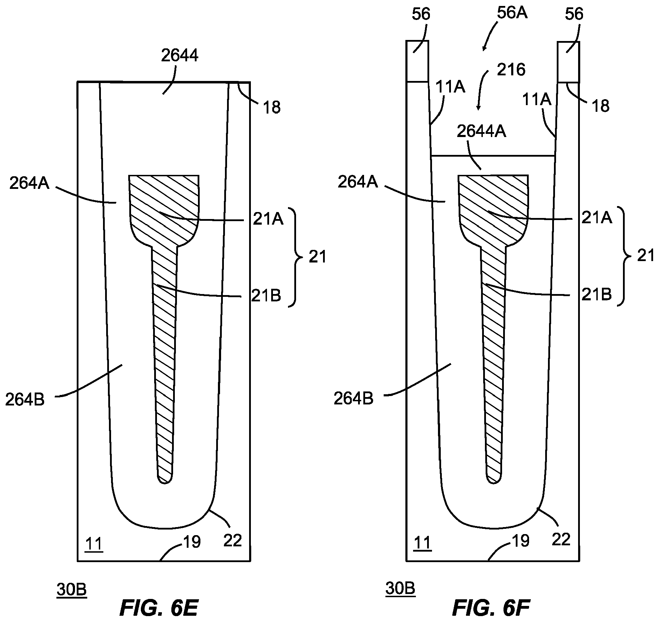

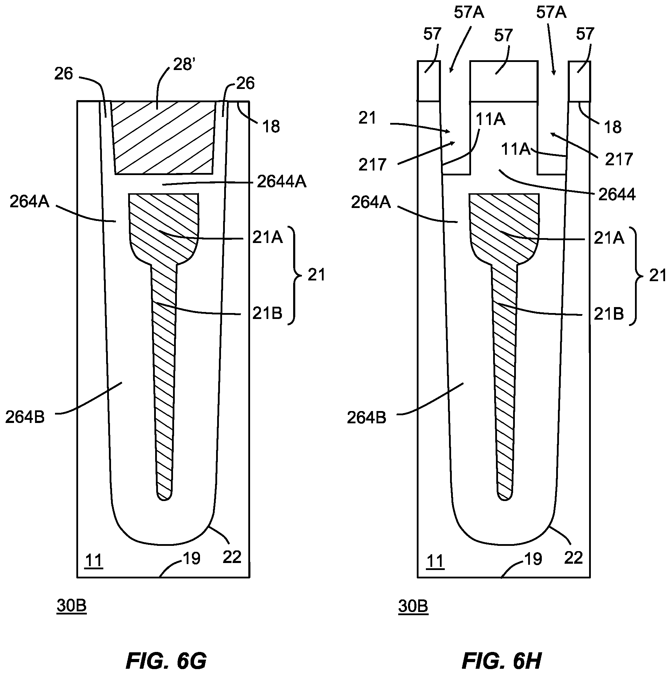

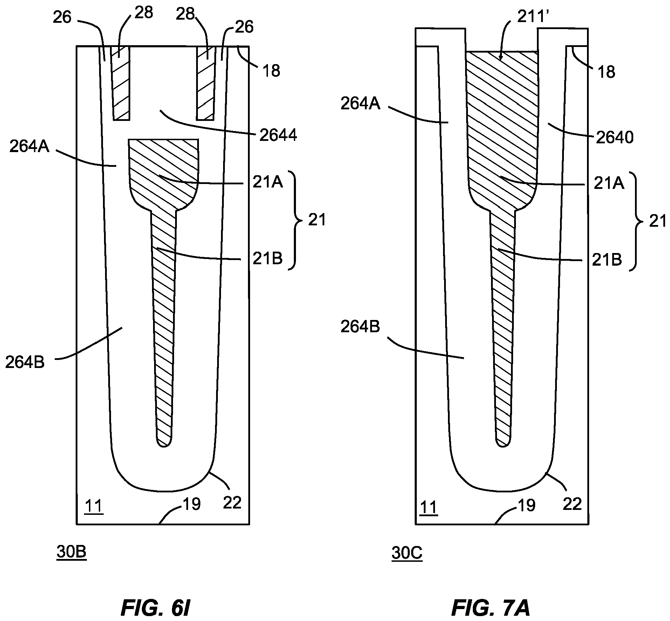

FIGS. 6A, 6B, 6C, 6D, 6E, 6F, 6G, 6H, and 6I illustrate partial cross-sectional views of a semiconductor device 30B in accordance with the present description at later stages of manufacture. In some examples, semiconductor device 30B can be provided based on the method described in FIGS. 4A-4E. The method described in FIGS. 6A-6I is an example method that provides a split gate structure or a bridge gate structure where the stepped shield electrode is recessed below the gate electrode(s). In some examples, this can include first portion 21A of stepped shield electrode 21 recessed below the lower side of gate electrode(s) 28.

FIG. 6A illustrates semiconductor device 30B at a stage of manufacture similar to semiconductor device 30 illustrated in FIG. 4E and the details will not be repeated again here. After conductor 211' is provided within trench 22, conductor 211' and dielectric 2640 can be removed and planarized to a location proximate to top side 18 as illustrated in FIG. 6B. In some examples, CMP can be used to planarize conductor 211' and dielectric 2640. In a next step, a mask 54 can be provided over portions of top side 18. In some examples, mask 54 comprises a polymer material, such as a photoresist, which is patterned to provide opening 54A that exposes conductor 211' and portions of dielectric 2640 and proximate to top side 18.

FIG. 6C illustrates semiconductor device 30B after further processing. In the present example, conductor 211' is partially removed to recess conductor 211' below top side 18 for provide recess 214 within trench 22. In some examples, when conductor 211' comprises polysilicon, a fluorinated dry-etch chemistry, such as SF₆ can be used to etch conductor 211' to form recess 214. This provides first portion 21A of stepped shield conductor 21 recessed below top side 18 within trench 22. In some examples, this configuration reduces the gate-to-shield capacitance. After recess 214 is provided, mask 54 can be removed. In some examples, a dielectric 2643 is then provided within recess 214 as illustrated in FIG. 6D. In some examples, dielectric 2643 comprises an oxide, a nitride, combinations thereof, or other materials as known to one of ordinary skill in the art. In some examples, dielectric 2642 comprises doped oxide. In some examples, dielectric 2642 comprises borosilicate glass (BSG) provided using CVD techniques.

FIG. 6E illustrates semiconductor device 30B after further processing. In the present example, dielectric 2643 can be removed and planarized to a location proximate to top side 18. In some examples, CMP techniques can be used to planarize dielectric 2643. For ease of understanding, dielectrics 2640 and 2643 are illustrated as dielectric structure 2644 above stepped shield electrode 21 within trench 22 in FIG. 6E. More particularly, in some examples, dielectric structure 2644 is a combination of dielectric 2640 and dielectric 2643.

FIGS. 6F, 6G, 6H, and 6I illustrate semiconductor device 30B in accordance with alternative embodiments for gate electrodes 28. More particularly, with stepped shield electrode 21 comprising a recessed stepped shield electrode, alternative structures for gate electrodes 28 are facilitated in accordance with the present description.

In FIG. 6F, a mask 56 can be provided over top side 18 and patterned to provide an opening 56A exposing dielectric structure 2644. In some examples, mask 56 can comprise a polymer, such as a patterned photoresist. Next, a first portion of dielectric structure 2644 is removed inward from top side leaving a second portion 2644A of dielectric structure 2644 overlying first portion 21A of stepped shield electrode 21. In some examples, second portion 2644A comprises or can be referred to as an IPD. In some examples, portions 11A of body of semiconductor material 11 can be exposed proximate to the upper parts of trench 22. In some examples, second portion 2644A comprises a thickness in range from about 2,000 Angstroms to about 5,000 Angstroms. In some examples, the first portion of dielectric structure 2644 is removed using dry etching techniques with a fluorinated chemistry. In some examples, this leaves a recess 216 above second portion 2644A within trench 22. In some examples, mask 56 is then removed. In other examples, the first portion of dielectric structure 2644 can be removed using wet etching techniques.

FIG. 6G illustrates semiconductor device 30B after further processing. In some examples, a sacrificial oxide can be provided along portions 11A within recess 216 and then stripped to prepare portions 11A for gate dielectric 26. Gate dielectric 26 can then be provided along portions 11A within recess 216 as described previously. Next, a conductor can be provided within recess 216 over gate dielectric 26 and second portion 2644A of dielectric structure 2644. In some examples, the conductor comprises polysilicon doped with an N-type conductivity dopant. In some examples, the conductor can be planarized using CMP techniques to provide gate electrode 28' within recess 216. In some examples, metals, silicides, or other conductors can be included as part of the gate electrode 28'. In the example illustrated in FIG. 6G, gate electrode 28' is configured as or can be referred to as a bridge gate electrode that extends to overlie recessed stepped shield electrode 21. In some examples, this configuration can be used to facilitate larger width gate contacts and to couple together gates electrodes 28 provided in a split gate configuration as will be described in more detail later. In some examples, semiconductor 30B of FIG. 6G can be further processed to provide ILD 41, conductive region 43, conductor 44, and conductor 46 as illustrated and described previously.

FIG. 6H illustrates semiconductor device 30B after additional processing with reference back to FIG. 6E. In the present example, a mask 57 can be provided over top side 18 and patterned to provide openings 57A exposing portions of dielectric structure 2644. In some examples, mask 57 can comprise a polymer, such as a patterned photoresist. Next, portions of dielectric structure 2644 are removed inward from top side to provide recesses 217 interposed between body of semiconductor material 11 and dielectric structure 2644. In some examples, dry etching with a fluorinated chemistry can be used to remove portions of dielectric structure 2644 to provide recesses 217. In some examples, portions 11A of body of semiconductor material 11 can be exposed proximate to the upper portion of trench 22. In some examples, mask 57 can be removed.

FIG. 6I illustrates semiconductor device 30B after further processing. In some examples, a sacrificial oxide can be provided along portions 11A within recesses 217 and then stripped to prepare portions 11A for gate dielectric 26. Gate dielectric 26 can then be provided along portions 11A within recesses 217 as described previously. Next, a conductor can be provided within recesses 217 over gate dielectric 26 and dielectric structure 2644. In some examples, the conductor comprises polysilicon doped with an N-type conductivity dopant. In some examples, the conductor can be planarized using CMP techniques to provide gate electrodes 28 within recesses 217. In some examples, metals, silicides, or other conductors can be included as part of gate electrodes 28. In the example illustrated in FIG. 6I, gate electrodes 28 are configured as or can be referred to as a split gate structure over recessed stepped shield electrode 21. This configuration reduces gate to shield capacitance in accordance with the present description. In some examples, the dielectric structure 2644 illustrated in FIG. 6I can comprise or be referred to as IPD. In some examples, semiconductor 30B of FIG. 6I can be further processed to provide ILD 41, conductive region 43, conductor 44, and conductor 46 as illustrated and described previously. As illustrated in FIG. 6I, a first gate electrode (for example, the left gate electrode 28) is proximate to a first side of trench 22 and a second gate electrode (for example, the right gate electrode 28) is proximate to a second side of trench 22 with the first gate electrode 28 laterally separated from the second gate electrode 28. The first gate electrode and the second gate electrode are examples of a split gate structure.

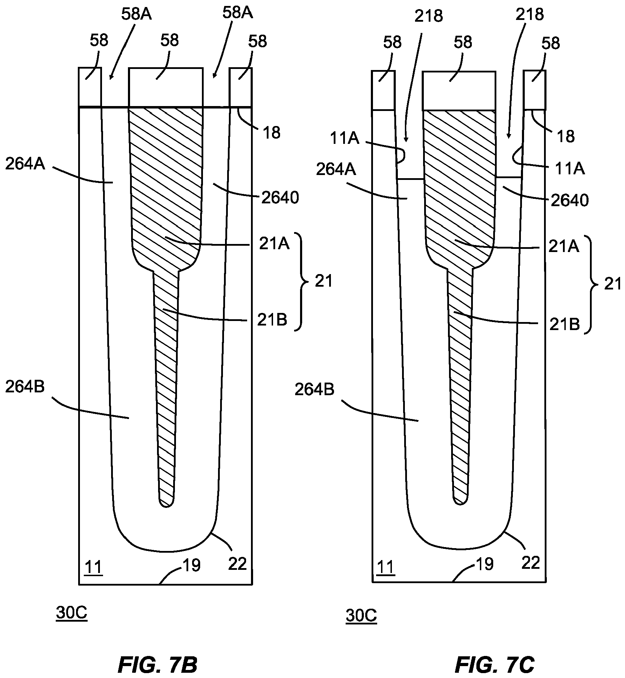

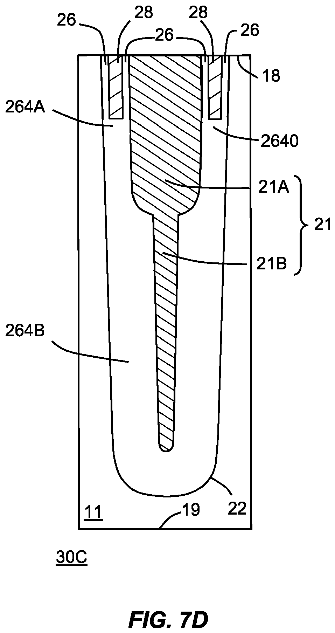

FIGS. 7A, 7B, 7C, and 7D illustrate partial sectional views of a semiconductor device 30C in accordance with the present description at later stages of manufacture. In some examples, semiconductor device 30C can be provided based on the method described in FIGS. 4A-4E. The method described in FIGS. 7A-7D is an example method that provides a split gate structure where stepped shield electrode 21 is laterally interposed between gate electrodes 28. In some examples, the top side of stepped shield electrode 21 can be substantially coplanar with top side 18.

FIG. 7A illustrates semiconductor device 30C at a stage of manufacture similar to semiconductor device 30A illustrated in FIG. 5A and the details will not be repeated again here. After conductor 211' is provided within trench 22, conductor 211' and dielectric 2640 can be removed and planarized to a location proximate to top side 18 as illustrated in FIG. 7B. In some examples, CMP can be used to planarize conductor 211' and dielectric 2640. In a next step, a mask 58 can be provided over portions of top side 18. In some examples, mask 58 comprises a polymer material, such as a photoresist, which is patterned to provide openings 58A that expose portions of dielectric 2640 proximate to top side 18.

FIG. 7C illustrates semiconductor device 30C after further processing. In the present example, portions of dielectric 2640 are removed inward from top side 18 to provide recesses 218 interposed between body of semiconductor material 11 and stepped shield electrode 21. In some examples, dry etching with a fluorinated chemistry can be used to remove portions of dielectric 2640 to provide recesses 218. In some examples, portions 11A of body of semiconductor material 11 can be exposed proximate to the upper parts of trench 22. In other examples, mask 58 can extend over portions of dielectric 2640 so that portions of dielectric 2640 remain adjacent to sidewalls of first portion 21A of stepped shield electrode 21. In some examples, mask 58 can then be removed.

FIG. 7D illustrates semiconductor device 30C after further processing. In some examples, a sacrificial oxide can be provided along portions 11A within recesses 218 and then stripped to prepare portions 11A for gate dielectric 26. Gate dielectric 26 can then be provided along portions 11A and sidewalls of first portion 21A of stepped shield electrode 21 within recesses 218 as described previously. In some examples, when thermal oxidation is used to form gate dielectric 26, the dielectric that forms along the sidewalls of first portion 21A can be thicker than the dielectric that forms along portions 11A in view of first portion 21A comprising polysilicon (which has a higher oxide growth rate) compared to portion 11A comprising single crystal semiconductor material.

Next, a conductor can be provided within recesses 218 over gate dielectric 26. In some examples, the conductor comprises polysilicon doped with an N-type conductivity dopant. In some examples, the conductor can be planarized using CMP techniques to provide gate electrodes 28 within recesses 218. In some examples, metals, silicides, or other conductors can be included as part of gate electrodes 28. In some examples, semiconductor 30C of FIG. 7D can be further processed to provide ILD 41, conductive region 43, conductor 44, and conductor 46 as illustrated and described previously. As illustrated in FIG. 7D, a first gate electrode (for example, the left gate electrode 28) is proximate to a first side of trench 22 and a second gate electrode (for example, the right gate electrode 28) is proximate to a second side of trench 22 with the first gate electrode 28 laterally separated from the second gate electrode 28. The first gate electrode and the second gate electrode are examples of a split gate structure.

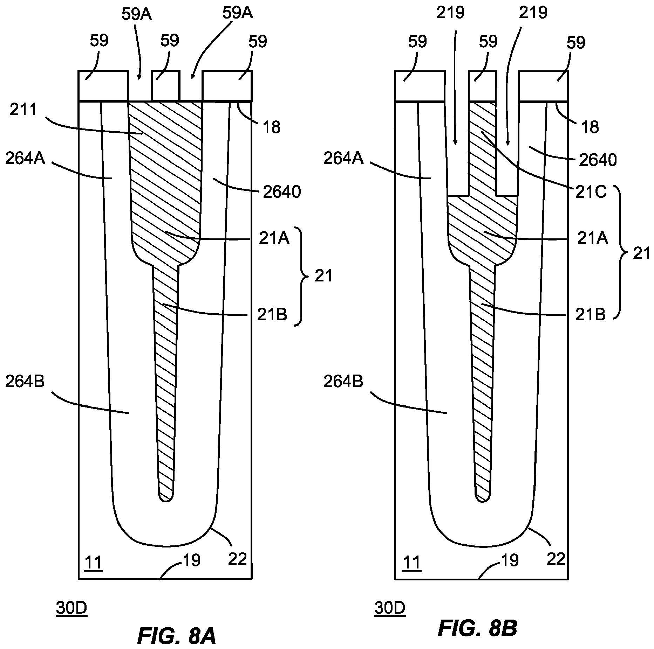

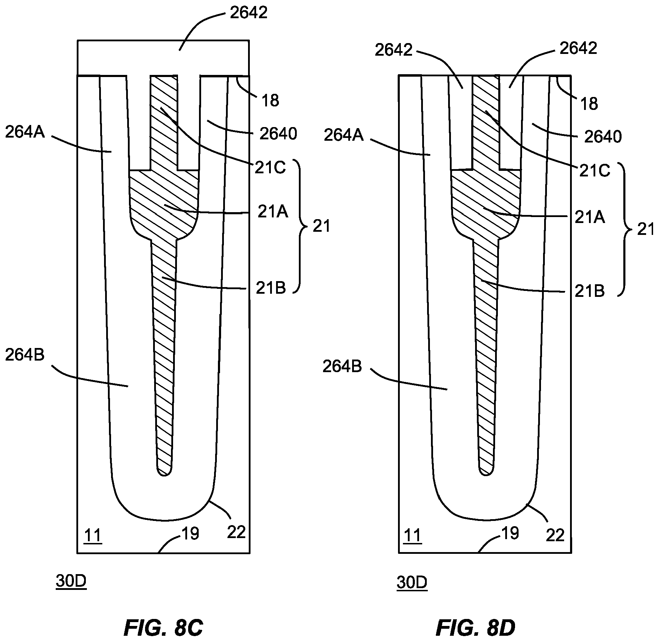

FIGS. 8A, 8B, 8C, and 8D illustrate partial sectional views of a semiconductor device 30D in accordance with the present description at later stages of manufacture. In some examples, semiconductor device 30D can be provided based on the method described in FIGS. 4A-4E. The method described in FIGS. 8A-8D is an example method that provides a split gate structure where stepped shield electrode 21 is laterally interposed between gate electrodes 28 and comprises third portion 21C as shown in FIG. 2.

FIG. 8A illustrates semiconductor device 30D after dielectric 2640 and conductor 211' have been planarized using, for example, CMP techniques. In some examples, the top side of stepped shield electrode 21 and the top side of dielectric 2640 can be substantially coplanar with top side 18. In the present example, a mask 59 s provided over top side 18. In some examples, a mask 59 can comprise a polymer, such as a patterned photoresist. In the present example, mask 59 is provided having openings 59A to expose lateral edge portions of stepped shield electrode 21.

FIG. 8B illustrates semiconductor device 30D after further processing. In the present example, upper lateral portions of stepped shield electrode 21 are removed to provide recesses 219. In some examples, recesses 219 extend partially inward from top side 18 and terminate within first portion 21A of stepped shield electrode 21. In some examples, when stepped shield electrode 21 comprises polysilicon, a fluorinated dry-etch chemistry, such as SF₆ can be used to form recesses 219. After recesses 219 are provided, mask 59 can be removed. In the present example, recesses 219 are deeper recesses compared to, for example, recesses 212 of semiconductor device 30A, which illustrates an example design variable (for example, height of third portion 21C) of the present description. In some examples, this design variable can be used to set the resistance of stepped shield electrode 21 or further isolate stepped shield electrode 21 from gate electrodes 28.

FIG. 8C illustrates semiconductor device 30D after further processing. In some examples, a dielectric 2642 is provided over top side 18 and within recesses 219. In some examples, dielectric 2642 comprises an oxide, a nitride, combinations thereof, or other materials as known to one of ordinary skill in the art. In some examples, dielectric 2642 comprises doped oxide. In some examples, dielectric 2642 comprises BSG provided using CVD techniques. In a subsequent step, dielectric 2642 can be planarized. In some examples, dielectric 2642 is removed and planarized to a location proximate to top side 18 as illustrated in FIG. 8D. In some examples, CMP can be used to planarize dielectric 2642. In some examples, third portion 21C is exposed between portions of dielectric 2642 remaining within recesses 219. In some examples, semiconductor device 30D can then be further processed to provide gate conductors 28 as described previously, for example, with FIGS. 5F and 5G. In some examples, semiconductor 30D can be further processed to provide ILD 41, conductive region 43, conductor 44, and conductor 46 as illustrated and described with FIG. 2.

FIGS. 9A, 10A, 11A, 12A, and 13A illustrate partial top views of example cell layouts for shielded-gate trench semiconductor devices in accordance with the present description. In the cell layouts illustrated, provision is made for configurations that reduce capacitive effects, that control shield resistance, or that make improved contact to gate electrodes 28, stepped shield electrodes 21, or non-stepped shield electrodes 210 in accordance with the present description.

It is to be noted that although some examples illustrated hereinafter show non-stepped shield electrodes 210, similar examples can include stepped shield electrodes 21 as previously shown and described in FIGS. 1, 2, and 3A-8D. Additionally, although some examples illustrated hereinafter show stepped shield electrodes 21, similar examples can include non-stepped shield electrodes 210. Further, any of the illustrated cell layouts can comprise both stepped shield electrodes 21 and non-stepped shield electrodes 210 in the same cell layout. This can include within the same elongate shield electrode stripe or in different elongate shield electrode stripes within the same cell layout or semiconductor device. In the examples that follow, reference is made to patterning processes that can be used to pattern the dielectric interposed between gate electrodes 28 and stepped shield electrode 21 or non-stepped shield electrode 210. As described previously, such dielectrics can comprise or be referred to as IPDs.

FIG. 9A is a partial top view of a cell layout 91 for a semiconductor device 90 in accordance with the present description. FIG. 9B illustrates a partial cross-sectional view of semiconductor device 90 taken along reference line 9B'-9B' and FIG. 9C illustrates a partial cross-sectional view of semiconductor device 90 taken along reference line 9C'-9C'. It is noted that although conductor 44 is illustrated in FIGS. 9B and 9C, conductor 44 is not included in FIG. 9A to show the features below conductor 44 in cell layout 91. Semiconductor device 90 is illustrated using semiconductor region 14 as a non-limiting example, which can be part of body of semiconductor material 11 including substrate 12 as described previously.

In the present example, cell layout 91 comprises elongate shield electrode stripe 2100, elongate split gate electrode stripes 2800, and conductive regions 43A laterally spaced along the length of elongate shield electrode stripe 2100 within trench 22 as shown in FIG. 9A. Conductive regions 43A are configured to provide electrical coupling to elongate shield electrode stripe 2100. In some examples, gate dielectric 26, doped regions 33, doped region 36, and trench 22 can be provided as elongate stripes generally parallel to elongate shield electrode stripe 2100 and elongate split gate electrode stripes 2800 as illustrated, for example, in FIG. 9A.

In accordance with the present description, elongate shield electrode stripe 2100 comprises a recessed shield electrode portion 21' and a contact shield electrode portion 21" along its length within trench 22. In some examples, recessed shield electrode portion 21' comprises first portion 21A and second portion 21B where second portion 21B is narrower in width than first portion 21A as described previously. In the present example, first portion 21A is recessed below and separated from the bottom sides of gate electrodes 28 by an IPD as illustrated in FIG. 9B. In some examples, the IPD can be similar to dielectric 2644A/2644 as described previously in conjunction with FIGS. 6A-6I or dielectric 264D/2642 as described previously in conjunction with FIGS. 5A-5G. In some examples, the IPD can comprise a thermal oxide, which can be patterned using dry etching or wet etching techniques.

In some examples, contact shield electrode portion 21" comprises first portion 21A, second portion 21B, and third portion 21C where second portion 21B and third portion 21C are narrower in width than first portion 21A. In the present example, conductive region 43A contacts third portion 21C of contact shield electrode portion 21" at a location that is laterally interposed between gate electrodes 28. In addition, thicker dielectric 264D (for example, thicker than gate dielectric 26) laterally separates third portion 21C from gate electrodes 28. As illustrated in FIGS. 9B and 9C, a first gate electrode (for example, the left gate electrode 28) is proximate to a first side of trench 22 and a second gate electrode (for example, the right gate electrode 28) is proximate to a second side of trench 22 with the first gate electrode 28 laterally separated from the second gate electrode 28. The first gate electrode and the second gate electrode are examples of a split gate structure. FIGS. 9A-9C illustrate an example where a portion of elongate shield electrode stripe 2100 is devoid of third portion 21C. It is noted that elongate shield electrode stripe 2100 comprises a portion that only has first portion 21A and second portion 21B as illustrated in FIG. 9B.

In accordance with the present description, semiconductor device 90 comprises improved performance by reducing gate capacitance and gate-to-shield capacitance by using, among other things, recessed shield electrode portion 21', third portion 21C of contact shield electrode portion 21", and thicker dielectric 264D. In addition, semiconductor device 90 comprises improved performance by using second portion 21B, which facilitates a higher dopant concentration in semiconductor region 14 to improve Rsp. Further, cell layout 91 facilitates contact to elongate shield electrode stripe 2100 without creating regions where gate electrodes 28 are left floating. In some examples, the resistance of the shield electrode can be controlled by using different shield electrode configurations in accordance with desired performance specifications. For example, by using recessed portions, wider portions, narrower portions, or modifying the dopant concentration. In some examples, the methods as described in conjunction with FIGS. 4A-8D can be used to provide semiconductor device 90.

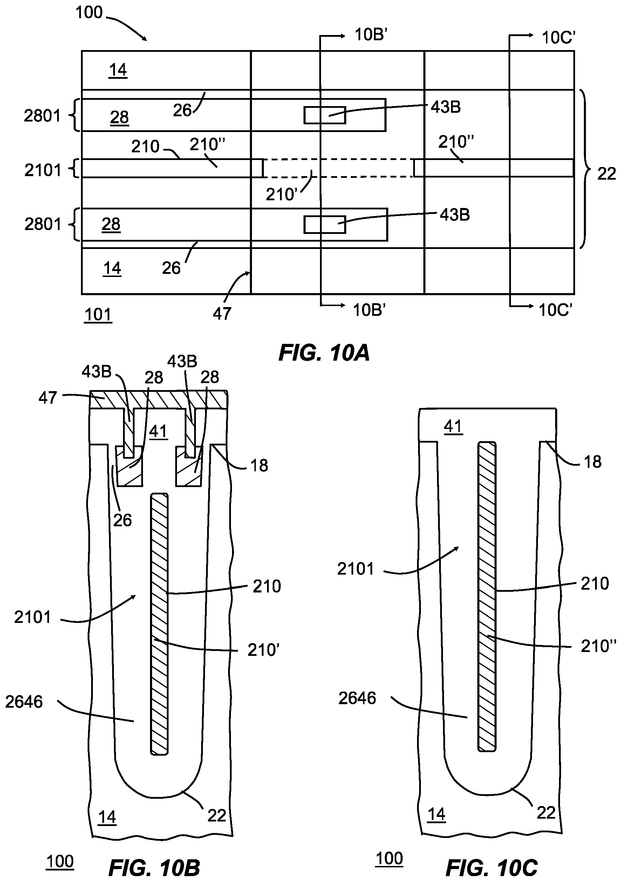

FIG. 10A is a partial top view of a cell layout 101 for a semiconductor device 100 in accordance with the present description. FIG. 10B illustrates a partial cross-sectional view of semiconductor device 100 taken along reference line 10B'-10B' of FIG. 10A and FIG. 10C illustrates a partial cross-sectional view of semiconductor device 100 taken along reference line 10C'-10C' of FIG. 10A. In the present example, cell layout 101 comprises elongate shield electrode stripe 2101 and elongate split gate electrode stripes 2801 within trench 22 as shown in FIG. 10A. Semiconductor device 100 is illustrated using semiconductor region 14, which can be part of body of semiconductor material 11 including substrate 12 as described previously. In addition, semiconductor device 100 is a non-limiting example of a semiconductor device that comprises non-stepped shield electrode 210 that includes a recessed portion 210' and a non-recessed portion 210" within the same elongate shield electrode stripe 2101. In some examples, non-stepped shield electrode 210 is separated from semiconductor region 14 by dielectric 2646, which can comprise materials similar to the dielectrics (for example, dielectric 264B) described previously.

In the present example, cell layout 101 can be example layout for an outer edge portion of semiconductor device 100 where a conductor 47 is provided to tie together conductive regions 43B, which are coupled to gate electrodes 28. In some examples, conductor 47 can comprise or be referred to as a gate coupling structure and can comprise materials similar to those described previously for conductor 44. It is noted that conductor 47 is illustrated in a see-through format in FIG. 10A to show the elements below conductor 47. In the present example, recessed portion 210' of non-stepped shield electrode 210 is provided under or below conductor 47, conductive regions 43B, and gate electrodes 28 as illustrated in FIG. 10B, which reduces gate capacitance and gate-to-shield capacitance in accordance with the present description. In this way, conductive contact to gate electrodes 28 is made where non-stepped shield electrode 210 is recessed, or where non-stepped shield electrode 210 comprises recessed portion 210'.

In the present example, recessed portion 210' is separated from gate electrodes 28 by an IPD as illustrated in FIG. 10B. In some examples, the IPD can be similar to dielectric 2644A/2644 as described previously in conjunction with FIGS. 6A-6I or dielectric 264D/2642 as described previously in conjunction with FIGS. 5A-5G. In some examples, the IPD can comprise a thermal oxide, which can be patterned using dry etching or wet etching techniques.

In some examples, portions of semiconductor device 100 where cell layout 101 is illustrated (i.e., outer edge portion) is provided devoid of doped region 31, doped regions 33, and doped region 36. It is understood that other portions of semiconductor device 100 can include such doped regions. FIG. 10C illustrates an example of a termination portion or area of semiconductor device 100 that comprises non-recessed portion 210" of non-stepped shield electrode 210 and that can be provided devoid of gate conductors 28. In some examples, the upper side of non-recessed portion 210" in the termination region can be substantially coplanar with top side 18. In some examples, contact can be made to non-recessed portion 210" to the left of conductor 47 in FIG. 10A using conductive regions 43A as described previously. In some examples, dry or wet etching techniques can be used to etch the IPD provided above to form vias in a thermal oxide above gate electrodes 28 for conductive regions 43B. As illustrated in FIG. 10B, a first gate electrode (for example, the left gate electrode 28) is proximate to a first side of trench 22 and a second gate electrode (for example, the right gate electrode 28) is proximate to a second side of trench 22 with the first gate electrode 28 laterally separated from the second gate electrode 28. The first gate electrode and the second gate electrode are examples of a split gate structure.

In accordance with the present description, semiconductor device 100 comprises improved performance by using recessed portion 210' below conductor 47 and below gate electrodes 28 reducing gate capacitance and gate-to-shield capacitance. In addition, semiconductor device 100 facilitates contact to elongate shield electrode stripe 2101 without creating regions where gate electrodes 28 are left floating. It is understood that in other examples, elongate shield electrode stripe 2101 or portions thereof can comprise a stepped shield electrode configuration. In some examples, the resistance of the shield electrode can be controlled by using different shield electrode configurations in accordance with desired performance specifications. For example, by using recessed portions, wider portions, narrower portions, or modifying the dopant concentration. In some examples, the methods as described in conjunction with FIGS. 4A-8D can be used to provide semiconductor device 100.

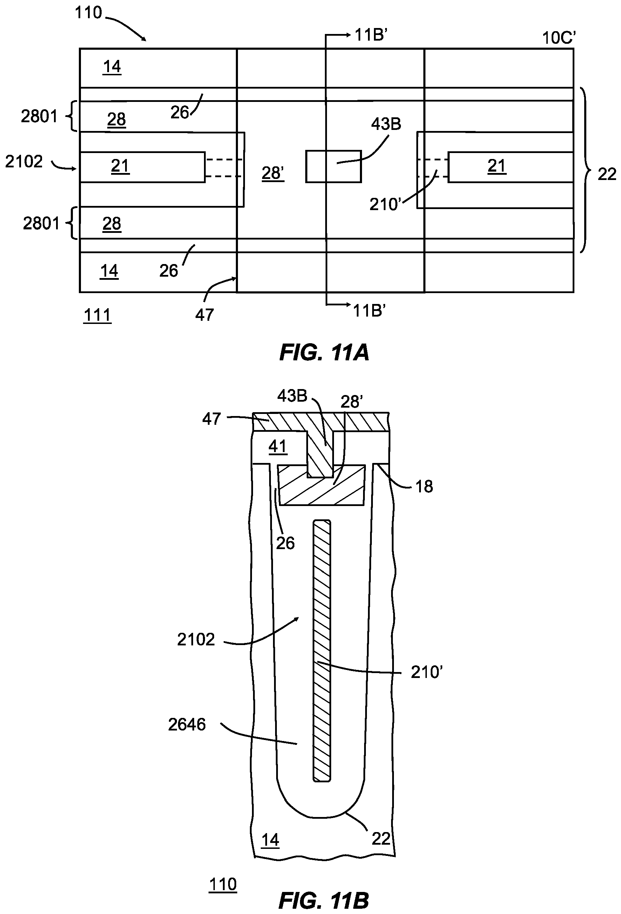

FIG. 11A is a partial top view of a cell layout 111 for a semiconductor device 110 in accordance with the present description. FIG. 11B illustrates a partial cross-sectional view of semiconductor device 100 taken along reference line 11B'-11B' of FIG. 11A. Semiconductor device 110 is illustrated using semiconductor region 14, which can be part of body of semiconductor material 11 including substrate 12 as described previously. the present example, cell layout 111 can be example layout for an outer edge portion of semiconductor device 110 where conductor 47 is provided to couple to gate electrode bridge portion 28' with conductive region 43B.

In the present example, cell layout 111 comprises elongate shield electrode stripe 2102, which can include one or more portions that comprises stepped shield electrode 21 and one or more other portions that comprises non-stepped shield electrode 210 within the same stripe. In the present example, non-stepped shield electrode 210 comprises recessed portion 210'. In some examples, portions of semiconductor device 110 where cell layout 111 is illustrated is provided devoid of doped region 31, doped regions 33, and doped region 36. It is understood that other portions of semiconductor device 110 can include such doped regions.

In the present example, a portion of cell layout 111 comprises gate electrodes 28 in a split gate configuration as elongate split gate electrode stripes 2801, and further comprises gate electrode bridge portion 28' that couples gate electrodes 28 together in another portion of cell layout 111. In some examples, conductive region 43B is provided coupled to gate electrode bridge portion 28' and conductor 47 is provided coupled to conductive region 43B. It is noted that conductor 47 is illustrated in a see-through format in FIG. 11A to show the elements below conductor 47. In the present example, recessed portion 210' of non-stepped shield electrode 210 is provided recessed below gate electrode portion 28' and is separated from gate electrode portion 28' by an IPD as illustrated in FIG. 11B. In some examples, the IPD can be similar to dielectric 2644A as described previously in conjunction with FIGS. 6A-6I. In some examples, the IPD can comprise a thermal oxide, which can be patterned using dry etching or wet etching techniques. In other examples, shield electrode 21, such as shield electrode 21 illustrated in FIG. 6G can be used in semiconductor device 110. In some examples, contact can be made to a portion of elongate shield electrode stripe 2102 comprising stepped shield electrode 21 to the left of conductor 47 in FIG. 11A using conductive regions 43A as described previously.

In accordance with the present description, semiconductor device 110 comprises improved performance by using recessed portion 210' below gate electrode bridge portion 28' to reduce gate capacitance and gate-to-shield capacitance. In addition, gate electrode bridge portion 28' facilitates an improved contact structure for contacting gate electrodes 28. Further, semiconductor device 110 facilitates contact to elongate shield electrode stripe 2102 without creating regions where gate electrodes 28 are left floating. It is understood that in other examples, elongate shield electrode stripe 2102 or portions thereof can comprise a non-stepped shield electrode configuration. In some examples, the resistance of the shield electrode can be controlled by using different shield electrode configurations in accordance with desired performance specifications. For example, by using recessed portions, wider portions, narrower portions, or modifying the dopant concentration. In some examples, the methods as described in conjunction with FIGS. 4A-8D can be used to provide semiconductor device 110.

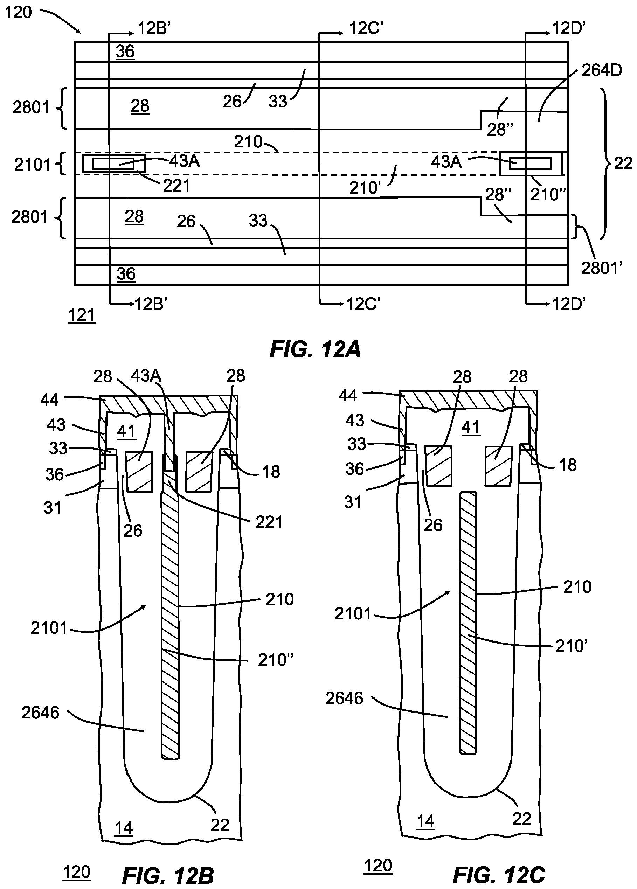

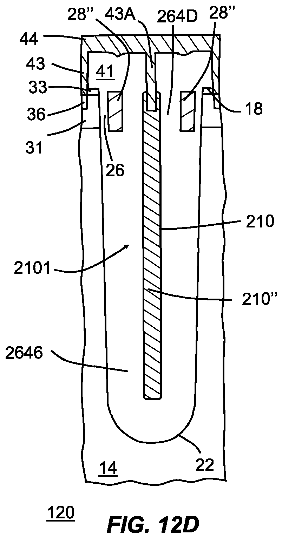

FIG. 12A is a partial top view of a cell layout 121 for a semiconductor device 120 in accordance with the present description. FIGS. 12B illustrates a partial cross-sectional view of semiconductor device 120 taken along reference line 12B'-12B' of FIG. 12A, FIG. 12C illustrates a partial cross-sectional view of semiconductor device 120 taken along reference line 12C'-12C' of FIG. 12A, and FIG. 12D illustrates a partial cross-sectional view of semiconductor device 120 taken along reference line 12D'-12D' of FIG. 12A. Semiconductor device 120 is illustrated using semiconductor region 14, which can be part of body of semiconductor material 11 including substrate 12 as described previously. In addition, semiconductor device 120 is a non-limiting example of a semiconductor device using non-stepped shield electrode 210, which comprises a recessed portion 210' and a non-recessed portion 210" within the same elongate shield electrode stripe 2101. It is noted that although conductor 44 is illustrated in FIGS. 12B, 12C, and 12D, conductor 44 is not included in FIG. 12A to show the features below conductor 44 in cell layout 121. In some examples, non-stepped shield electrode 210 is separated from semiconductor region 14 by dielectric 2646.

In the present example, cell layout 121 comprises elongate shield electrode stripe 2101, elongate split gate electrode stripes 2801 and conductive regions 43A laterally spaced along elongate shield electrode stripe 2101. In some examples, elongate shield electrode stripe 2101 comprises non-stepped shield electrode 210 including recessed portion 210' and non-recessed portion 210". In the present example, non-stepped shield electrode 210 is separated from gate electrodes 28 by an IPD as illustrated in FIGS. 12B, 12C, and 12D. In some examples, the IPD can be similar to dielectric 2644A/2644 as described previously in conjunction with FIGS. 6A-6I or dielectric 264D/2642 as described previously in conjunction with FIGS. 5A-5G. In some examples, the IPD can comprise a thermal oxide, which can be patterned using dry etching or wet etching techniques. In some examples, gate dielectric 26, doped regions 33, doped region 36, and trench 22 are provided as elongate stripes generally parallel to elongate shield electrode stripe 2101 and elongate split gate electrode stripes 2801.

In the portion of semiconductor device 120 illustrated in FIG. 12B, non-recessed portion 210" of non-stepped shield electrode 210 comprises portion 221 proximate to conductive region 43A. Portion 221 comprises a narrower lateral width than another part of portion 210" below portion 221. In some examples, portion 221 is provided in a laterally narrower configuration based on the formation of gate dielectric 26 using thermal oxidation techniques. In this way, the thermal oxide that forms along the sides of non-stepped shield electrode 210 consumes the polysilicon material of non-stepped shield electrode 210 at a higher rate than the thermal oxide that forms along the upper sidewalls of trench 22. In some examples, this increases the dielectric thickness between gate electrodes 28 and non-stepped shield electrode 210 but can reduce the area for contacting non-stepped shield electrode 210 with conductive region 43A. As illustrated in FIG. 12C, non-stepped shield electrode 210 of semiconductor device 120 comprises recessed portion 210' that is recessed below gate electrodes 28 in one or more portions of elongate shield stripe 2101.

In accordance with the present description, elongate split gate electrode stripes 2801 comprise narrower elongate gate electrode stripe portions 2801' that are coupled to elongate split gate electrode stripes 2801. In some examples, narrower elongate gate electrode stripe portions 2801' facilitate using thicker IPD (for example, dielectric 264D) between gate electrodes 28" and non-stepped shield electrode 210 as illustrates in FIG. 12D. In accordance with the present example, gate electrodes 28" have a narrower lateral width compared to gate electrodes 28. In some examples, a masking step can be used to protect non-stepped shield electrode 210 and provide thicker dielectric 264D along the side portions of non-stepped shield electrode 210 to reduce the likelihood of forming portion 221 as illustrated in FIG. 12B, which is narrower than the remainder of non-stepped shield electrode 210 below portion 221. Among other things, this provides more area for contacting conductive region 43A proximate to top side 18 and further provides increased isolation between non-stepped shield electrode 210 and gate electrodes 28 where non-stepped shield electrode 210 contacts conductive region 43A. FIG. 12A illustrates an example where narrower elongate gate electrode stripe portions 2801' are adjacent one of conductive region 43A.

As illustrated in FIGS. 12B, 12C, and 12D, a first gate electrode (for example, the left gate electrode 28 or 28") is proximate to a first side of trench 22 and a second gate electrode (for example, the right gate electrode 28 or 28") is proximate to a second side of trench 22 with the first gate electrode 28 laterally separated from the second gate electrode. The first gate electrode and the second gate electrode are examples of a split gate structure.

In accordance with the present description, semiconductor device 120 comprises improved performance by using recessed portion 210' below gate conductors 28 in some regions of semiconductor device, and by using thicker dielectric 264D in other regions of semiconductor device 120 to reduce gate capacitance and gate-to-shield capacitance. More particularly, cell layout 121 is an example where the elongate gate stripe 2801 comprises a first portion (wide portion of elongate gate electrode stripe 2801) and a second portion (narrower elongate gate electrode stripe portion 2801') where the second portion is coupled to the first portion but comprises a narrower lateral width compared to the first portion. This configuration facilities thicker dielectric 264D in some regions of semiconductor device 120.

In addition, semiconductor device 120 facilitates contact to elongate shield electrode stripe 2101 without creating regions where gate electrodes 28 are left floating. Further, semiconductor device 120 comprises non-stepped shield electrode 210 that has portions that are wider proximate to top side 18 than other portions of semiconductor device 120, which facilitates improved contact to conductive regions 43A. In some examples, the resistance of the shield electrode can be controlled by using different shield electrode configurations in accordance with desired performance specifications. For example, by using recessed portions, wider portions, narrower portions, or modifying the dopant concentration. It is understood that in other examples, elongate shield electrode stripe 2101 or portions thereof can comprise a stepped shield electrode configuration. In some examples, the methods as described in conjunction with FIGS. 4A-8D can be used to provide semiconductor device 120.

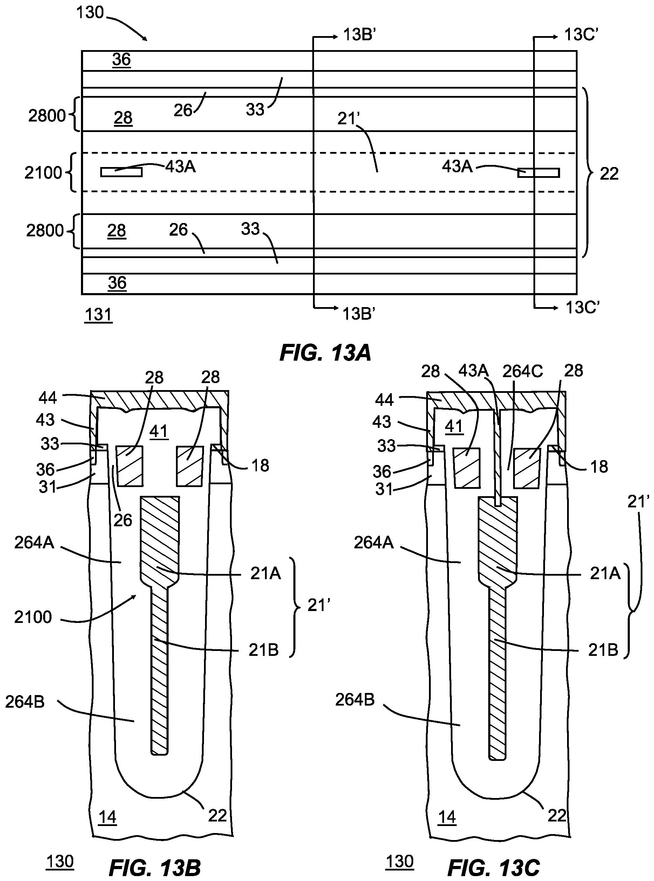

FIG. 13A is a partial top view of a cell layout 131 for a semiconductor device 130 in accordance with the present description. FIG. 13B illustrates a partial cross-sectional view of semiconductor device 130 taken along reference line 13B'-13B' of FIG. 13A and FIG. 13C illustrates a partial cross-sectional view of semiconductor device 130 taken along reference line 13C'-13C' of FIG. 13A. It is noted that although conductor 44 is illustrated in FIGS. 13B and 13C, conductor 44 is not included in FIG. 13A to show the features below conductor 44. Semiconductor device 130 is illustrated using semiconductor region 14, which can be part of body of semiconductor material 11 including substrate 11 as described previously.

In the present example, cell layout 131 comprises elongate shield electrode stripe 2100, elongate split gate electrode stripes 2800, and conductive regions 43A laterally spaced along elongate shield electrode stripe 2100 as illustrated in FIG. 13A. In some examples, gate dielectric 26, doped regions 33, doped region 36, and trench 22 are provided as elongate stripes generally parallel to elongate shield electrode stripe 2100 and elongate split gate stripes 2800.

In accordance with the present description, elongate shield electrode stripe 2100 comprises recessed shield electrode portion 21' along its entire length within trench 22. In the present example, recessed shield electrode portion 21' comprises a stepped shield electrode configuration including first portion 21A and second portion 21B below first portion 21A with first portion 21A being wider than second portion 21B as described previously. In the present example, first portion 21A is recessed below and separated from the bottom sides of gate electrodes 28 by an IPD as illustrated in FIGS. 13B and 13C. In some examples, the IPD can be similar to dielectric 2644A/2644 as described previously in conjunction with FIGS. 6A-6I or dielectric 264D/2642 as described previously in conjunction with FIGS. 5A-5G. In some examples, the IPD can comprise a thermal oxide, which can be patterned using dry etching or wet etching techniques.

As illustrated in FIG. 13C, conductive regions 43A extend through ILD 41 and the IPD and contact recessed shield electrode portion 21' below gate electrodes 28 within trench 22. Conductive regions 43A can be disposed along elongate shield electrode stripe 2100 as illustrated in FIG. 13A. As illustrated in FIGS. 13B and 13C, a first gate electrode (for example, the left gate electrode 28) is proximate to a first side of trench 22 and a second gate electrode (for example, the right gate electrode 28) is proximate to a second side of trench 22 with the first gate electrode 28 laterally separated from the second gate electrode 28. The first gate electrode and the second gate electrode are examples of a split gate structure.

In accordance with the present description, semiconductor device 130 comprises improved performance by using recessed shield electrode portion to reduce gate capacitance and gate-to-shield capacitance. In addition, semiconductor device 130 comprises improved performance by using a stepped shield electrode including second portion 21B, which facilitates a higher dopant concentration in semiconductor region 14 to improve Rsp. Further, cell layout 131 facilitates contact to elongate shield electrode stripe 2100 without creating regions where gate electrodes 28 are left floating. It is understood that in other examples, elongate shield electrode stripe 2100 or portions thereof can comprise a non-stepped shield electrode configuration. In some examples, the resistance of the shield electrode can be controlled by using different shield electrode configurations in accordance with desired performance specifications. For example, by using recessed portions, wider portions, narrower portions, or modifying the dopant concentration. In some examples, the methods as described in conjunction with FIGS. 4A-8D can be used to provide semiconductor device 130.

From all the foregoing, one of ordinary skill the art can determine that in an example, the first gate electrode can comprise a first bottom side, the second gate electrode comprises a second bottom side, and the first portion of the stepped shield electrode comprises a top side recessed below the first bottom side and the second bottom side. In another example, a conductive region can be coupled to the first portion at a location below the first bottom side and below the second bottom side. In a further example, conductive regions can be coupled to the elongate stepped shield electrode stripe along its length. In a still further example, a conductive region can be coupled to the stepped shield electrode, wherein the first elongate gate electrode stripe comprises a wide portion and a narrow portion; and the narrow portion is laterally adjacent to the conductive region. In another example, the semiconductor device can further comprise a first doped region of a second conductivity type opposite the first conductivity type in the body of semiconductor material adjacent to the trench; and a second doped region of the first conductivity type in the first doped region, wherein the first portion of the stepped shield electrode and the first dielectric are adjacent to the body of semiconductor material at a location proximate to a bottom side of the first doped region.

In summary, structures and methods have been described for a semiconductor device having improved manufacturability and performance. More particularly, structures and methods are described that reduce shield resistance, reduce capacitive coupling effects between the shield electrode and the gate electrode, improve specific on-resistance, and avoid using regions where the gate electrode is left floating. In a non-limiting example, the structures and methods are relevant to shielded-gate trench MOSFETs having a voltage rating between approximately 100V and 250V or more.

In some examples, a stepped shield electrode and a split gate electrode configuration is used that includes a thinner dielectric proximate to the body diode region of the semiconductor device, which facilitates a higher dopant concentration in the drift region to reduce specific on-resistance. In some examples, the lateral width of the upper shield electrode is reduced to provide a thicker sidewall dielectric between the shield electrode and the gate electrode, which facilitates a reduced cell pitch to further reduce specific on-resistance. In some examples, the stepped shield electrode or shield contacts at the surface of the semiconductor device can be continuous or intermittent along the length of trench. In some examples, the stepped shield electrode can be recessed in some segments within the trench where shield contacts are absent to provide design flexibility for setting shield resistance. In some examples, the stepped shield electrode can be intermittently recessed within the trench and covered by a dielectric to provide design flexibility for setting shield resistance and to reduce gate to shield capacitance.

It is understood that the different examples described herein can be combined with any of the other examples described herein to obtain different embodiments.

While the subject matter of the invention is described with specific preferred examples, the foregoing drawings and descriptions thereof depict only typical examples of the subject matter and are not therefore to be considered limiting of its scope. It is evident that many alternatives and variations will be apparent to those skilled in the art. For example, the conductivity types of the various regions can be reversed. Also, other IV-IV semiconductor materials besides SiC, such as SiGe or SiGeC can be used. Additionally, other compound semiconductor materials can be used.

As the claims hereinafter reflect, inventive aspects may lie in less than all features of a single foregoing disclosed example. Thus, the hereinafter expressed claims are hereby expressly incorporated into this Description, with each claim standing on its own as a separate example of the invention. Furthermore, while some examples described herein include some, but not other features included in other examples, combinations of features of different examples are meant to be within the scope of the invention and meant to form different examples as would be understood by those skilled in the art.

## Claims

1. A semiconductor device, comprising:
a body of semiconductor material comprising:
a top side;
a bottom side opposite to the top side; and
a first conductivity type;
a trench extending from the top side into the body of semiconductor material;
a stepped shield electrode within the trench comprising:
a first portion comprising a first width; and
a second portion below and coupled to the first portion and comprising a second width less than the first width;
a first dielectric separating the first portion from the body of semiconductor material;
a second dielectric separating the second portion from the body of semiconductor material;
a split gate electrode structure within the trench and comprising a first gate electrode proximate to a first side of the trench and second gate electrode proximate to a second side of the trench opposite to the first side, wherein the first gate electrode is laterally separated from the second gate electrode;
a gate dielectric separating the first gate electrode from the body of semiconductor material at the first side of the trench and separating the second gate electrode from the body of semiconductor material at the second side of the trench; and
a third dielectric separating the stepped shield electrode from the first gate electrode and the second gate electrode.

2. The semiconductor device of claim 1, wherein:
the stepped shield electrode comprises a third portion above and coupled to the first portion and comprising a third width less than the first width.

3. The semiconductor device of claim 2, wherein:
the third dielectric laterally separates the third portion from the first gate electrode and the second gate electrode; and
the third dielectric comprises a thickness greater than that of the gate dielectric.

4. The semiconductor device of claim 1, wherein:
the stepped shield electrode comprises an elongate stepped shield electrode stripe;
the first gate electrode comprises a first elongate gate electrode stripe; and
the second gate electrode comprises a second elongate gate electrode stripe.

5. The semiconductor device of claim 4, further comprising:
a gate electrode bridge portion coupled to the first elongate gate electrode stripe and the second elongate gate electrode stripe; and
a gate coupling structure coupled to the gate electrode bridge portion,
wherein:
the first portion of the stepped shield electrode is recessed below the first gate electrode and the second gate electrode at a location below the gate electrode bridge portion.

6. A semiconductor device, comprising:
a body of semiconductor material comprising:
a top side;
a bottom side opposite to the top side; and
a first conductivity type;
a trench within the body of semiconductor material extending inward from the top side;
a stepped shield electrode within the trench comprising:
a first portion comprising a first width;
a second portion below and coupled to the first portion and comprising a second width less than the first width; and
a third portion above and coupled to the first portion and comprising a third width less than the first width;
a first dielectric separating the first portion from the body of semiconductor material;
a second dielectric separating the second portion from the body of semiconductor material;
a split gate electrode structure within the trench and comprising a first gate electrode proximate to a first side of the trench and second gate electrode proximate to a second side of the trench opposite to the first side, wherein the first gate electrode is laterally separated from the second gate electrode;
a gate dielectric separating the first gate electrode from the body of semiconductor material at the first side of the trench and separating the second gate electrode from the body of semiconductor material at the second side of the trench; and
a third dielectric separating the third portion of the stepped shield electrode from the first gate electrode and the second gate electrode, wherein the third dielectric is thicker than the gate dielectric.

7. The semiconductor device of claim 6, wherein:
the stepped shield electrode comprises an elongate stepped shield electrode stripe;
the first gate electrode comprises a first elongate gate electrode stripe; and
the second gate electrode comprises a second elongate gate electrode stripe.

8. The semiconductor device of claim 7, wherein:
a portion of the elongate stepped shield electrode stripe is devoid of the third portion.

9. The semiconductor device of claim 7, further comprising:
a gate electrode bridge portion coupled to the first elongate gate electrode stripe and the second elongate gate electrode stripe; and
a gate coupling structure coupled to the gate electrode bridge portion.

10. The semiconductor device of claim 7, further comprising:
a conductive region coupled to the stepped shield electrode;
wherein:
the first elongate gate electrode stripe comprises a wide portion and a narrow portion; and
the narrow portion is laterally adjacent to the conductive region.

11. The semiconductor device of claim 6, further comprising:
a conductive region coupled to the third portion; and
a conductor over the top side coupled to the conductive region.

12. The semiconductor device of claim 6, further comprising:
a first doped region of a second conductivity type opposite the first conductivity type in the body of semiconductor material adjacent to the trench; and
a second doped region of the first conductivity type in the first doped region;
wherein:
the first portion of the stepped shield electrode and the first dielectric are adjacent to the body of semiconductor material at a location proximate to a bottom side of the first doped region.

13. A method of manufacturing a semiconductor device, comprising:
providing a body of semiconductor material comprising:
a top side;
a bottom side opposite to the top side; and
a first conductivity type;
providing a trench extending from the top side into the body of semiconductor material;
providing a stepped shield electrode within the trench comprising:
a first portion comprising a first width; and
a second portion below and coupled to the first portion and comprising a second width less than the first width;
providing a first dielectric separating the first portion from the body of semiconductor material;
providing a second dielectric separating the second portion from the body of semiconductor material;
providing a split gate electrode structure within the trench and comprising a first gate electrode proximate to a first side of the trench and second gate electrode proximate to a second side of the trench opposite to the first side, wherein the first gate electrode is laterally separated from the second gate electrode;
providing a gate dielectric separating the first gate electrode from the body of semiconductor material at the first side of the trench and separating the second gate electrode from the body of semiconductor material at the second side of the trench; and
providing a third dielectric separating the stepped shield electrode from the first gate electrode and the second gate electrode.

14. The method of claim 13, wherein:
providing stepped shield electrode comprises providing a third portion above and coupled to the first portion and comprising a third width less than the first width;
providing the third dielectric comprises providing the third dielectric laterally separating the third portion from the first gate electrode and the second gate electrode; and
the third dielectric comprises a thickness greater than that of the gate dielectric.

15. The method of claim 13, wherein:
providing the split gate electrode structure comprises:
providing the first gate electrode comprising a first bottom side; and
providing the second gate electrode comprising a second bottom side; and
providing the stepped shield electrode comprises providing the first portion comprising a top side recessed below the first bottom side and the second bottom side.

## Amended claims

### Amended claims in accordance with Rule 137(2) EPC.

1. A semiconductor device (10, 20, 30, 90, 100, 110, 120, 130), comprising:
a body of semiconductor material (11) comprising:
a top side (18);
a bottom side (19) opposite to the top side (18); and
a first conductivity type;
a trench (22) within the body of semiconductor material (11) extending inward from the top side (18);
a stepped shield electrode (21) within the trench (22) comprising:
a first portion (21A) comprising a first width;
a second portion (21B) below and coupled to the first portion (21A) and comprising a second width less than the first width; and
a third portion (21C) above and coupled to the first portion (21A) and comprising a third width less than the first width;
a first dielectric (264A) separating the first portion (21A) from the body of semiconductor material (11);
a second dielectric (264B) separating the second portion (21B) from the body of semiconductor material (11);
a split gate electrode structure within the trench (22) and comprising a first gate electrode (28) proximate to a first side of the trench (22) and second gate electrode (28) proximate to a second side of the trench (22) opposite to the first side, wherein the first gate electrode (28) is laterally separated from the second gate electrode (28);
a gate dielectric (26) separating the first gate electrode (28) from the body of semiconductor material (11) at the first side of the trench (22) and separating the second gate electrode (28) from the body of semiconductor material (11) at the second side of the trench (22); and
a third dielectric (264C, 264D) separating the third portion (21C) of the stepped shield electrode (21) from the first gate electrode (28) and the second gate electrode (28),
**characterized in that**
the third dielectric (264C, 264D) is thicker than the gate dielectric (26),
wherein:
the stepped shield electrode (21) comprises an elongate stepped shield electrode stripe (2100, 2101);
the first gate electrode (28) comprises a first elongate gate electrode stripe (2801); and
the second gate electrode (28) comprises a second elongate gate electrode stripe (2801').

2. The semiconductor device (10, 20, 30, 90, 100, 110, 120, 130) of claim 1, wherein:
a portion of the elongate stepped shield electrode stripe (2100, 2101) is devoid of the third portion (21C).

3. The semiconductor device (10, 20, 30, 90, 100, 110, 120, 130) of claim 1, further comprising:
a gate electrode bridge portion (28') coupled to the first elongate gate electrode stripe (2801) and the second elongate gate electrode stripe (2801'); and
a gate coupling structure (47) coupled to the gate electrode bridge portion (28').

4. The semiconductor device (10, 20, 30, 90, 100, 110, 120, 130) of claim 1, further comprising:
a conductive region (43, 43A, 43B) coupled to the stepped shield electrode (21);
wherein:
the first elongate gate electrode stripe (2801) comprises a wide portion and a narrow portion; and
the narrow portion is laterally adjacent to the conductive region (43, 43A, 43B).

5. The semiconductor device (10, 20, 30, 90, 100, 110, 120, 130) of claim 1, further comprising:
a conductive region (43, 43A, 43B) coupled to the third portion (21C); and
a conductor (44, 46, 211, 211') over the top side coupled to the conductive region (43, 43A, 43B).

6. The semiconductor device (10, 20, 30, 90, 100, 110, 120, 130) of claim 1, further comprising:
a first doped region (33, 36) of a second conductivity type opposite the first conductivity type in the body of semiconductor material (11) adjacent to the trench (22); and
a second doped region (33, 36) of the first conductivity type in the first doped region (33, 36);
wherein:
the first portion (21A) of the stepped shield electrode (21) and the first dielectric (264A) are adjacent to the body of semiconductor material (11) at a location proximate to a bottom side of the first doped region (33, 36).

7. A method of manufacturing a semiconductor device (10, 20, 30, 90, 100, 110, 120, 130), comprising:
providing a body of semiconductor material (11) comprising:
a top side (18);
a bottom side (19) opposite to the top side (18); and
a first conductivity type;
providing a trench (22) extending from the top side (18) into the body of semiconductor material (11);
providing a stepped shield electrode (21) within the trench (22) comprising:
a first portion (21A) comprising a first width; and
a second portion (21B) below and coupled to the first portion (21A) and comprising a second width less than the first width;
providing a first dielectric (264A) separating the first portion (21A) from the body of semiconductor material (11);
providing a second dielectric (264B) separating the second portion (21B) from the body of semiconductor material (11);
providing a split gate electrode structure within the trench (22) and comprising a first gate electrode (28) proximate to a first side of the trench (22) and a second gate electrode (28) proximate to a second side of the trench (22) opposite to the first side, wherein the first gate electrode (28) is laterally separated from the second gate electrode (28);
providing a gate dielectric (26) separating the first gate electrode (28) from the body of semiconductor material (11) at the first side of the trench (22) and separating the second gate electrode (28) from the body of semiconductor material (11) at the second side of the trench (22); and
providing a third dielectric (264C, 264D) separating the stepped shield electrode (21) from the first gate electrode (28) and the second gate electrode (28),
wherein:
providing stepped shield electrode (21) comprises providing a third portion (21C) above and coupled to the first portion (21A) and comprising a third width less than the first width; and
providing the third dielectric (264C, 264D) comprises providing the third dielectric (264C, 264D) laterally separating the third portion (21C) from the first gate electrode (28) and the second gate electrode (28),
**characterized in that**
the third dielectric (264C, 264D) comprises a thickness greater than that of the gate dielectric (26),
wherein:
the stepped shield electrode (21) comprises an elongate stepped shield electrode stripe (2100, 2101);
the first gate electrode (28) comprises a first elongate gate electrode stripe (2801); and
the second gate electrode (28) comprises a second elongate gate electrode stripe (2801').

8. The method of claim 7, wherein:
providing the split gate electrode structure comprises:
providing the first gate electrode (28) comprising a first bottom side; and
providing the second gate electrode (28) comprising a second bottom side; and
providing the stepped shield electrode (21) comprises providing the first portion (21A) comprising a top side recessed below the first bottom side and the second bottom side.
